(19) Europäisches Patentamt
European Patent Office
Office européen des brevets

(11) **EP 2 005 420 B1**

(12) **FASCICULE DE BREVET EUROPEEN**

(45) Date de publication et mention de la délivrance du brevet:
**26.10.2011 Bulletin 2011/43**

(51) Int Cl.:
***G10L 19/00*** *(2006.01)*

(21) Numéro de dépôt: **07731712.1**

(86) Numéro de dépôt international:
**PCT/FR2007/050896**

(22) Date de dépôt: **08.03.2007**

(87) Numéro de publication internationale:
**WO 2007/104882 (20.09.2007 Gazette 2007/38)**

(54) **DISPOSITIF ET PROCEDE DE CODAGE PAR ANALYSE EN COMPOSANTE PRINCIPALE D'UN SIGNAL AUDIO MULTI-CANAL**

EINRICHTUNG UND VERFAHREN ZUR CODIERUNG DURCH HAUPTKOMPONENTENANALYSE EINES MEHRKANALIGEN AUDIOSIGNALS

DEVICE AND METHOD FOR ENCODING BY PRINCIPAL COMPONENT ANALYSIS A MULTICHANNEL AUDIO SIGNAL

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **15.03.2006 FR 0650882**

(43) Date de publication de la demande:
**24.12.2008 Bulletin 2008/52**

(73) Titulaire: **FRANCE TELECOM**
**75015 Paris (FR)**

(72) Inventeurs:
• **BRIAND, Manuel**
**c/o Márcia Rodeiro**
**18268 Djursholm (SE)**
• **VIRETTE, David**
**22560 Pleumer Bodou (FR)**

(56) Documents cités:
**WO-A-03/085645     WO-A-2006/000952**

• **MANUEL BRIAND, DAVID VIRETTE ET NADINE MARTIN: "Parametric representation of multichannel audio based on principal component analysis" 120TH AES, 20 mai 2006 (2006-05-20), page PAPER 6813, XP008069356 Paris, France**

**Description**

Domaine technique de l'invention

L'invention se rapporte au domaine de codage par analyse en composante principale d'un signal audio multi-canal pour des transmissions audionumériques sur divers réseaux de transmission à différents débits. Plus particulièrement, l'invention vise à permettre la transmission à bas débit des signaux audio multicanaux de type stéréophonique (2 canaux) ou 5.1 (6 canaux) ou autres.

Arrière-plan de l'invention

Dans le cadre du codage des signaux audio multicanaux, deux approches sont particulièrement connues et utilisées.

La première et plus ancienne consiste à matricer les canaux du signal multi-canal original de manière à réduire le nombre de signaux à transmettre. A titre d'exemple, le procédé de codage audio multi-canal Dolby® Pro Logic® II réalise le matriçage des six canaux d'un signal 5.1 en deux signaux à transmettre. Plusieurs types de décodage peuvent être réalisés de façon à reconstruire au mieux les six canaux originaux.

La seconde approche, appelée codage audio paramétrique, se base sur l'extraction de paramètres de spatialisation pour reconstituer la perception spatiale de l'auditeur. Cette approche se base principalement sur un procédé appelé « Binaural Cue Coding » (BCC) qui vise d'une part à extraire puis coder les indices de la localisation auditive et d'autre part à coder un signal monophonique ou stéréophonique issu du matriçage du signal multi-canal original.

En outre, il existe une approche hybride des deux approches ci-dessus basée sur une méthode appelée « Analyse en Composante Principale » (ACP). En effet, l'ACP peut être vue comme un matriçage dynamique des canaux du signal multi-canal à coder. Plus précisément, l'ACP est obtenue par une rotation des données dont l'angle correspond à la position spatiale des sources sonores dominantes du moins pour le cas stéréophonique. Cette transformation est d'ailleurs considérée comme la méthode de décorrélation optimale qui permet de compacter l'énergie des composantes d'un signal multi-composantes. Un exemple de codage audio stéréophonique à base d'ACP est divulgué dans les documents WO 03/085643 et WO 03/085645.

Cependant, l'ACP réalisée selon l'art antérieur ne permet pas l'obtention d'une caractérisation fine des signaux à coder et par conséquent, l'énergie des signaux issus de cette analyse n'est pas assez compactée dans la composante principale.

Objet et résumé de l'invention

La présente invention concerne un procédé de codage par analyse en composante principale (ACP) d'un signal audio multi-canal. Ce procédé comporte les étapes suivantes :

- décomposer au moins deux canaux du signal audio en une pluralité de sous-bandes fréquentielles ;
- calculer au moins un paramètre de transformation en fonction d'au moins une partie de la pluralité de sous-bandes fréquentielles ;
- transformer au moins une partie de la pluralité de sous-bandes fréquentielles en une pluralité de sous-composantes fréquentielles en fonction dudit au moins un paramètre de transformation, la pluralité de sous-composantes fréquentielles comportant des sous-composantes principales fréquentielles ;
- combiner au moins une partie des sous-composantes principales fréquentielles pour former une composante principale ; et
- définir un signal audio codé représentant le signal audio multi-canal, le signal audio codé comportant la composante principale et ledit au moins un paramètre de transformation.

Ainsi, l'analyse en composante principale selon l'invention est une analyse dans le domaine fréquentiel par sous-bandes de fréquence qui peuvent être établies selon une échelle équivalente à celle des bandes critiques de l'audition et permet d'obtenir une caractérisation plus fine des signaux à coder. Par conséquent, l'énergie des signaux issus de l'analyse en composante principale ACP réalisée par sous-bandes de fréquence est d'avantage compactée dans la composante principale comparée à l'énergie des signaux issus d'une ACP réalisée dans le domaine temporel.

Alors, le signal audio codé qui est un signal bien compacté du signal audio multi-canal original, peut être transmis sur un réseau de transmission à faible débit et ceci indépendamment du nombre de canaux du signal original tout en permettant la reconstruction d'un signal audio de bonne qualité, assez proche perceptuellement du signal audio original.

Selon une caractéristique de l'invention, la pluralité de sous-composantes fréquentielles comporte en outre des sous-composantes résiduelles fréquentielles.

Les sous-composantes résiduelles fréquentielles sont représentatives des sources sonores secondaires et ambiances décorrélées et peuvent être utilisées pour mieux reproduire l'ambiance sonore.

Selon une autre caractéristique de l'invention, le procédé de codage selon l'invention comporte une formation/extraction d'un ensemble de paramètres énergétiques par sous-bandes de fréquence en fonction des sous-composantes résiduelles fréquentielles.

Selon une autre caractéristique de l'invention, l'ensemble de paramètres énergétiques est formé par une extraction des différences d'énergie par sous-bandes de fréquence entre les sous-composantes principales fréquentielles et les sous-composantes résiduelles fréquentielles.

Selon une autre caractéristique de l'invention, l'ensemble de paramètres énergétiques correspond aux énergies par sous-bandes de fréquence des sous-composantes résiduelles fréquentielles.

L'extraction des différences d'énergies ou énergies par sous-bandes de fréquence des sous-composantes résiduelles permet une transmission bande par bande de l'énergie correspondante à l'ambiance sonore.

Selon une autre caractéristique de l'invention, le procédé de codage selon l'invention comporte un filtrage des sous-composantes principales fréquentielles avant l'extraction de l'ensemble de paramètres énergétiques.

Ceci permet de compenser une éventuelle modification d'amplitude au cas où le filtrage utilisé également au décodage modifie l'amplitude des signaux.

Selon une autre caractéristique de l'invention, le signal audio codé comporte en outre au moins un paramètre énergétique parmi l'ensemble de paramètres énergétiques.

Ainsi, l'ambiance sonore peut être facilement synthétisée à partir de la composante principale et du paramètre énergétique compris dans le signal audio codé améliorant davantage la perception du signal audio original.

Selon une autre caractéristique de l'invention, le procédé de codage selon l'invention comporte une combinaison d'au moins une partie des sous-composantes résiduelles fréquentielles pour former au moins une composante résiduelle, le signal audio codé comportant en outre ladite au moins une composante résiduelle.

C'est une variante qui permet aussi de reconstituer l'ambiance sonore c'est-à-dire le signal original au mieux à partir du signal audio codé.

Selon une autre caractéristique de l'invention, le procédé de codage selon l'invention comporte une analyse de corrélation entre lesdits au moins deux canaux pour déterminer une valeur de corrélation correspondante, le signal audio codé comportant en outre cette valeur de corrélation.

Ainsi, la valeur de corrélation peut indiquer une éventuelle présence de réverbération dans le signal original permettant d'améliorer la qualité du décodage du signal codé.

Selon une autre caractéristique de l'invention, la pluralité de sous-bandes fréquentielles est définie suivant une échelle perceptuelle.

Ainsi, le procédé de codage tient compte de la résolution fréquentielle du système auditif humain.

Selon une autre caractéristique de l'invention, la définition du signal audio codé comporte un codage audio de la composante principale et une quantification dudit au moins un paramètre de transformation et/ou une quantification dudit au moins un paramètre énergétique, et/ou une quantification de ladite au moins une composante résiduelle.

Ainsi, le signal audio codé peut être facilement transmis sur divers réseaux de transmission à différents débits.

On notera que, dans le cas du codage de plus de 2 canaux, il serait alors possible de coder les (au moins) 2 composantes principales avec un codeur stéréo ou autre.

Selon une autre caractéristique de l'invention, le signal audio est défini par une succession de trames de sorte que lesdits au moins deux canaux sont définies pour chaque trame.

Ceci permet d'augmenter la finesse de l'analyse en composante principale et par conséquent d'améliorer la qualité du signal codé.

Selon une autre caractéristique de l'invention, le signal audio multi-canal est un signal stéréophonique.

Selon une autre caractéristique de l'invention, le signal audio multi-canal est un signal audio au format 5.1 comportant les canaux suivants : Gauche, Central, Droit, Arrière Gauche, Arrière Droit, et Basse Fréquences.

Selon une autre caractéristique de l'invention, le procédé de codage selon l'invention comporte la formation d'un premier triplet de signaux comportant les canaux Gauche, Central, et Arrière Gauche et d'un second triplet de signaux comportant les canaux Droit, Central, et Arrière Droit, les premier et second triplets étant utilisés séparément pour former des première et seconde composantes principale selon des paramètres de transformation comportant des premiers et seconds angles d'Euler respectivement.

L'invention vise également un procédé de décodage d'un signal de réception comportant un signal audio codé construit selon le procédé de codage décrit ci-avant. Ce procédé de décodage comporte les étapes suivantes :

- recevoir le signal audio codé ;
- extraire une composante principale décodée et au moins un paramètre de transformation décodé ;
- décomposer la composante principale décodée en des sous-composantes principales fréquentielles décodées ;
- transformer les sous-composantes principales fréquentielles décodées en une pluralité de sous-bandes fréquentielles décodées ; et
- combiner les sous-bandes fréquentielles décodées pour former au moins deux canaux décodés correspondant auxdits au moins deux canaux issus du signal audio multi-canal original.

Selon une caractéristique de l'invention, le procédé de décodage selon l'invention comporte la quantification inverse des paramètres énergétiques compris dans le signal audio codé pour synthétiser des sous-composantes résiduelles fréquentielles décodées.

Selon une autre caractéristique de l'invention, le procédé de décodage selon l'invention comporte une étape de décorrélation des sous-composantes résiduelles fréquentielles décodées pour former des sous-composantes résiduelles décorrélées.

Selon une autre caractéristique de l'invention, la décorrélation du procédé de décodage selon l'invention est réalisée par un filtrage de décorrélation ou de réverbération selon la valeur de corrélation comprise dans le signal audio codé.

L'invention vise également un encodeur par analyse en composante principale (ACP) d'un signal audio multi-canal, comprenant :

- des moyens de décomposition pour décomposer au moins deux canaux du signal audio en une pluralité de sous-bandes fréquentielles,
- des moyens de calcul pour calculer au moins un paramètre de transformation en fonction d'au moins une partie de la pluralité de sous-bandes fréquentielles,
- des moyens de transformation pour transformer au moins une partie de la pluralité de sous-bandes fréquentielles en une pluralité de sous-composantes fréquentielles en fonction dudit au moins un paramètre de transformation, la pluralité de sous-composantes fréquentielles comportant des sous-composantes principales fréquentielles,
- des moyens de combinaison pour combiner au moins une partie des sous-composantes principales fréquentielles afin de former une composante principale, et
- des moyens de définition pour définir un signal audio codé représentant le signal audio multi-canal, le signal audio codé comportant la composante principale et ledit au moins un paramètre de transformation.

L'invention vise également un décodeur d'un signal de réception comportant un signal audio codé issu d'un signal multi-canal original comprenant au moins deux canaux. Ce décodeur comporte :

- des moyens d'extraction pour extraire une composante principale décodée et au moins un paramètre de transformation décodé,
- des moyens de décomposition de décodage pour décomposer la composante principale décodée en des sous-composantes principales fréquentielles décodées,
- des moyens de transformation inverse pour transformer les sous-composantes principales fréquentielles décodées en une pluralité de sous-bandes fréquentielles décodées, et
- des moyens de combinaison de décodage pour combiner les sous-bandes fréquentielles décodées afin de former au moins deux canaux décodés correspondant auxdits au moins deux canaux issus du signal audio multi-canal original.

L'invention vise également un système comportant l'encodeur et le décodeur selon l'invention, tels que décrits ci-dessus.

En variante, les différentes étapes des procédés de codage et de décodage décrits ci-dessus sont déterminées par des instructions de programmes d'ordinateurs.

En conséquence, l'invention vise également un programme d'ordinateur comportant des instructions pour l'exécution des étapes du procédé de codage et/ou de décodage décrits ci-dessus lorsque ledit programme est exécuté par un ordinateur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise également un support d'enregistrement lisible par un ordinateur sur lequel est enregistré un programme d'ordinateur comprenant des instructions pour l'exécution des étapes du procédé de codage et/ou de décodage décrits ci-avant.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution des procédés en question.

Ainsi la présente invention utilise un procédé de codage des signaux issus de l'ACP plus adapté aux caractéristiques des signaux que celui décrit dans les documents de l'art antérieur WO 03/085643 et WO 03/085645. En effet, la méthode décrite dans ces documents utilise la prédiction linéaire des signaux issus de l'ACP. Or, la prédiction linéaire est un procédé adapté au codage de signaux corrélés qui produit un signal d'erreur, relatif à la différence des signaux traités, à faible énergie. Par conséquent, la prédiction linéaire, utilisée dans ces documents, appliquée aux signaux décorrélés issus de l'ACP n'est pas adaptée.

C'est pourquoi, la présente invention propose une nouvelle méthode de codage des signaux issus de l'ACP basée sur une analyse fréquentielle par sous-bande de fréquence qui permet l'extraction des différences d'énergies entre les composantes issues de l'ACP ou la transmission (après quantification) de l'énergie bande par bande de la composante ambiance.

Il convient de préciser que l'ACP, réalisée par sous-bande de fréquence, délivre des composantes à bande limitée à partir desquelles l'analyse fréquentielle par sous-bande de fréquence est immédiate. Ainsi le décodeur peut générer la composante à faible énergie issue de l'ACP à partir de la composante principale énergétique codée et transmise, et des paramètres énergétiques quantifiés et transmis.

De façon à obtenir des composantes décorrélées l'une de l'autre, le décodeur utilise, par défaut, un filtre passe-tout dit de décorrélation. Alors qu'un filtre de réverbération est préconisé dans les documents WO 03/085643 et WO 03/085645, la présente invention propose un basculement entre un filtre de décorrélation et un filtre de réverbération seulement lorsque l'analyse des signaux réalisée à l'encodage a détecté la présence de réverbération dans les signaux originaux. En effet, seul un indice est calculé à l'encodeur et transmis pour chaque trame traitée de façon à informer le décodeur du type de filtre à utiliser. Ce basculement entre les filtres à utiliser permet alors d'éviter de réverbérer des signaux qui ne le sont pas à l'origine et donc d'améliorer la qualité audio des signaux décodés.

Enfin, la présente invention propose un nouveau procédé de codage adapté au codage des signaux de type 5.1 qui constitue une extension du procédé de codage des signaux stéréophonique basé sur l'ACP en sous-bandes. Pour cela, une ACP tridimensionnelle est mise en oeuvre et paramétrée par les angles d'Euler. Cette extension peut également servir de base au codage audio paramétrique de scène sonore plus riche en nombre de canaux (par exemple pour les formats 6.1, 7.1, ambisonique, etc.).

Brève description des dessins

D'autres particularités et avantages de l'invention ressortiront à la lecture de la description faite, ci-après, à titre indicatif mais non limitatif, en référence aux dessins annexés, sur lesquels :

- la figure 1 est une vue schématique d'un système de communication comprenant un dispositif de codage et un dispositif de décodage selon l'invention ;
- la figure 2 est une vue schématique d'un encodeur selon l'invention;
- les figures 3 et 4 sont des variantes de la figure 2 ;
- la figure 5 est une vue schématique d'un décodeur selon l'invention ;
- la figure 6 est une variante de la figure 5 ;
- les figures 7 à 15 sont des vues schématiques des encodeurs et décodeurs selon les modes de réalisation particuliers de l'invention ; et
- la figure 16 est une vue schématique d'un système informatique mettant en oeuvre l'encodeur et le décodeur selon les figures 1 à 15.

Description détaillée de modes de réalisation

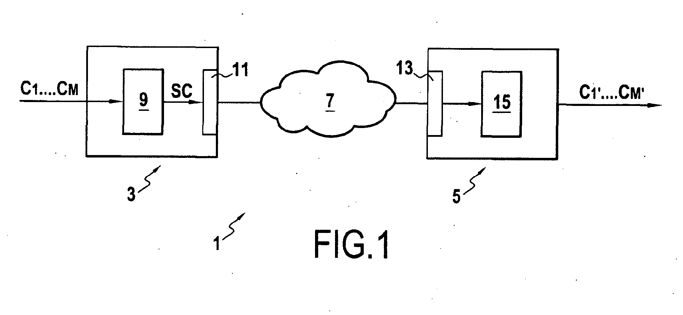

Conformément à l'invention, la figure 1 est une vue schématique d'un système de communication 1 comprenant un dispositif de codage 3 et un dispositif de décodage 5. Les dispositifs de codage 3 et de décodage 5 peuvent être reliés entre eux par l'intermédiaire d'un réseau ou ligne de communication 7.

Le dispositif de codage 3 comprend un encodeur 9 qui en recevant un signal audio multi-canal $C_1,...,C_M$ génère un signal audio codé SC représentatif du signal audio multi-canal $C_1,...,C_M$ original.

L'encodeur 9 peut être connecté à un moyen de transmission 11 pour transmettre le signal codé SC via le réseau de communication 7 au dispositif de décodage 5.

Le dispositif de décodage 5 comprend un récepteur 13 pour recevoir le signal codé SC transmis par le dispositif de codage 3. En outre, le dispositif de décodage 5 comprend un décodeur 15 qui en recevant le signal codé SC, génère un signal audio décodé $C'_1,...,C'_M$ correspondant au signal audio multi-canal $C_1,...,C_M$ original.

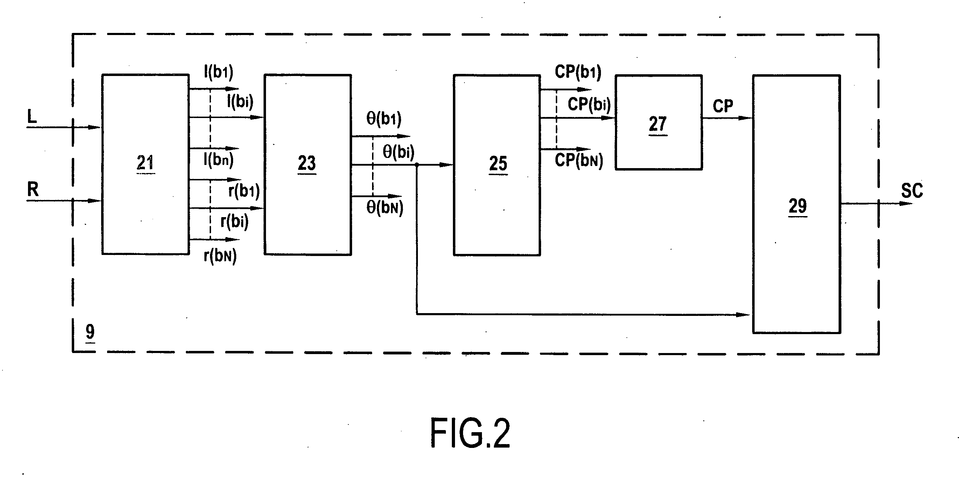

La figure 2 est une vue schématique de l'encodeur 9 comportant des moyens de décomposition 21, des moyens de calcul 23, des moyens de transformation 25, des moyens de combinaison 27 et des moyens de définition 29. La figure 2 est également une illustration des principales étapes du procédé de codage selon l'invention.

Les moyens de décomposition 21 sont destinés à décomposer au moins deux canaux L et R du signal audio multi-canal $C_1,...,C_M$ en une pluralité de sous-bandes fréquentielles $l(b_1),..., l(b_N), r(b_1),..., r(b_N)$.

Avantageusement, la pluralité de sous-bandes fréquentielles $l(b_1),..., l(b_N), r(b_1),..., r(b_N)$ est définie suivant une échelle perceptuelle.

Par ailleurs, la décomposition des deux canaux L et R peut être réalisée en transformant d'abord chaque canal temporel L ou R en un canal fréquentiel formant ainsi deux composantes fréquentielles. A titre d'exemple, la formation de ces deux signaux fréquentiels est réalisée par application d'une transformée de Fourier à court terme (TFCT) aux deux canaux L et R. Ensuite, on peut grouper les coefficients fréquentiels des signaux fréquentiels en sous-bandes $(b_1,...,b_N)$ pour obtenir la pluralité de sous-bandes fréquentielles $l(b_1),..., l(b_N), r(b_1),..., r(b_N)$.

Les moyens de calcul 23 sont destinés à calculer au moins un paramètre de transformation $\theta(b_i)$ parmi une pluralité de paramètres de transformation $\theta(b_1),..., \theta(b_N)$ en fonction d'au moins une partie de la pluralité de sous-bandes fréquentielles.

A titre d'exemple, le calcul des paramètres de transformation peut être réalisé en calculant une matrice de covariance pour chaque sous-bande fréquentielle de la pluralité de sous-bandes fréquentielles $l(b_1), ... l(b_N), r(b_1),..., r(b_N)$. Ainsi, la matrice de covariance permet de calculer des valeurs propres pour chaque sous-bande fréquentielle. Finalement, ces valeurs propres permettent de calculer les paramètres de transformation θ($b_1$),..., θ($b_N$).

Ainsi, à chaque sous-bande fréquentielle $b_i$ peut correspondre un paramètre de transformation θ($b_i$) définissant un angle de rotation correspondant à la position de la source dominante de la sous-bande fréquentielle.

On notera qu'il est également possible de calculer les paramètres de transformation uniquement à partir d'une covariance des deux canaux, originaux L et R.

Les moyens de transformation 25 sont destinés à transformer par ACP au moins une partie de la pluralité de sous-bandes fréquentielles l($b_1$),...,l($b_N$), r($b_1$),...,r($b_N$) en une pluralité de sous-composantes fréquentielles en fonction d'au moins un paramètre de transformation θ($b_i$). La pluralité de sous-composantes fréquentielles comportent des sous-composantes principales fréquentielles CP($b_1$),...,CP($b_N$).

En effet, le paramètre de transformation θ($b_i$) permet de réaliser une rotation des données par sous bande de fréquence qui résulte en une composante principale CP($b_i$) dont l'énergie correspond à la plus grande valeur propre calculée pour la sous-bande $b_i$.

Les moyens de combinaison 27 sont destinés à combiner au moins une partie des sous-composantes principales fréquentielles CP($b_1$),..., CP($b_N$) pour former une unique composante principale CP.

Ceci peut être réalisé en sommant les sous-composantes principales fréquentielles CP($b_1$),..., CP($b_N$) pour former une composante principale fréquentielle. Ensuite une transformée de Fourier à court terme inverse (TFCT)$^{-1}$ est appliquée sur la composante principale fréquentielle pour former une composante principale CP temporelle.

Les moyens de définition 29 sont destinés à définir un signal audio codé SC représentant le signal audio multi-canal $C_1$,...,$C_M$. Ce signal audio codé SC comporte la composante principale CP et au moins un paramètre de transformation θ($b_i$) parmi la pluralité de paramètres de transformation θ($b_1$),..., θ($b_N$).

Ainsi, une ACP par sous-bandes de fréquence permet d'obtenir une caractérisation plus fine des signaux à coder. Par conséquent, l'énergie des signaux issus de l'ACP réalisée par sous-bandes de fréquence est d'avantage compactée dans la composante principale comparée à l'énergie des signaux issus d'une ACP réalisée dans le domaine temporel.

On notera que le signal audio multi-canal peut être défini par une succession de trames n, n+1, etc. de sorte que les deux canaux L et R sont définis pour chaque trame n.

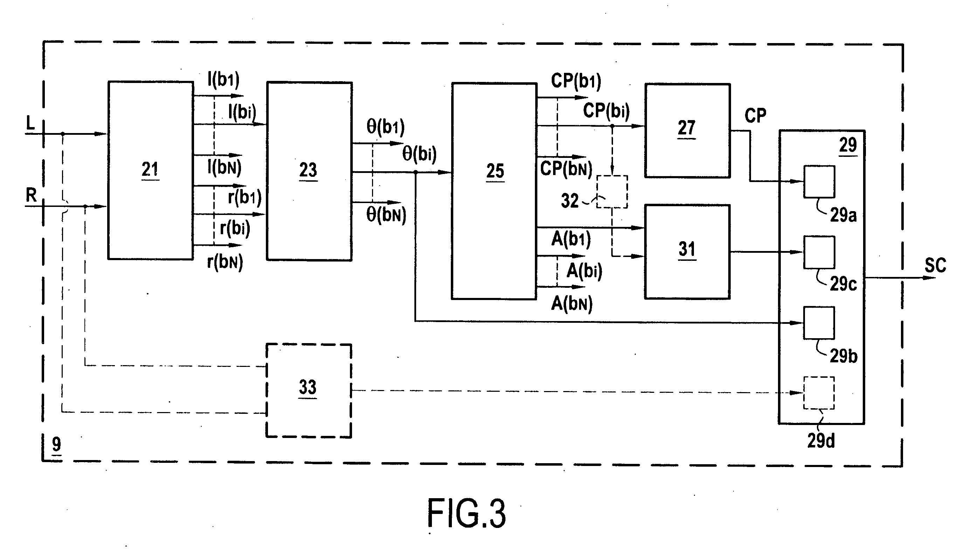

La figure 3 est une variante de la figure 2 montrant que la pluralité de sous-composantes fréquentielles comporte en outre des sous-composantes résiduelles fréquentielles A($b_1$),..., A($b_N$).

En effet, pour chaque sous-bande fréquentielle, le paramètre de transformation θ($b_i$) permet de réaliser une rotation des données par sous bande de fréquence qui résulte en une composante principale CP($b_i$) et au moins une composante résiduelle A($b_i$). L'énergie d'une composante résiduelle A($b_i$) est aussi proportionnelle à la valeur propre qui lui est associée. On notera que la valeur propre associée à une composante principale CP($b_i$) est plus grande que celle associée à une composante résiduelle A($b_i$). Par conséquent, l'énergie d'une composante résiduelle A($b_i$) est plus faible que l'énergie d'une composante principale CP($b_i$).

Ainsi, l'encodeur 9 comporte des moyens d'analyse fréquentielle 31 destiné à former au moins un paramètre énergétique E($b_i$) parmi un ensemble de paramètres énergétiques E($b_1$),..., E($b_N$) en fonction des sous-composantes résiduelles fréquentielles A($b_1$),..., A($b_N$) et/ou sous-composantes principales fréquentielles CP($b_1$),..., CP($b_N$).

Selon un premier mode de réalisation, les paramètres énergétiques E($b_1$),..., E($b_N$) sont formés par une extraction des différences d'énergie par sous-bandes de fréquence entre les sous-composantes principales fréquentielles CP($b_1$),..., CP($b_N$) et les sous-composantes résiduelles fréquentielles A($b_1$),..., A($b_N$).

Selon un autre mode de réalisation, les paramètres énergétiques E($b_1$),..., E($b_N$) correspondent directement à l'énergie par sous-bandes de fréquence des sous-composantes résiduelles fréquentielles A($b_1$),..., A($b_N$).

En outre, afin de compenser une éventuelle modification d'amplitude, l'encodeur 9 peut comporter des moyens de filtrage 32 pour filtrer les sous-composantes principales fréquentielles avant l'extraction des paramètres énergétiques E($b_1$),..., E($b_N$).

Par conséquent, afin de mieux synthétiser l'ambiance sonore, le signal audio codé SC peut avantageusement comporter au moins un paramètre énergétique parmi l'ensemble de paramètres énergétiques E($b_1$),..., E($b_N$).

Par ailleurs, l'encodeur 9 peut comporter des moyens d'analyse de corrélation 33 pour réaliser une analyse de corrélation temporelle entre les deux canaux L et R afin de déterminer un indice ou une valeur de corrélation c correspondante. Ainsi, le signal audio codé SC peut avantageusement comporter cette valeur de corrélation c pour indiquer une éventuelle présence de réverbération dans le signal original.

Les moyens de définition 29 peuvent comporter un moyen de codage audio 29a pour coder la composante principale CP et des moyens de quantification 29b, 29c, 29d pour quantifier le ou les paramètres de transformation, le ou les paramètres énergétiques E.

Eventuellement, dans le cas du codage de plus de deux canaux, il est possible de coder les au moins deux composantes principales résultantes avec un moyen de codage stéréo ou autre.

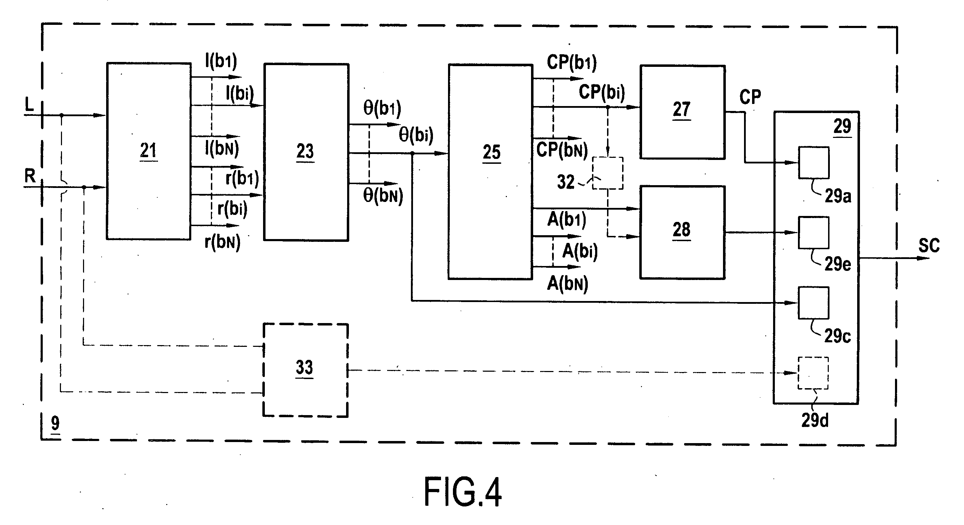

La figure 4 est une variante montrant un encodeur 9 qui se distingue de celui de la figure 3 uniquement par le fait que les moyens d'analyse fréquentielle 31 sont remplacés par d'autres moyens de combinaison 28 permettant de combiner au moins une partie des sous-composantes résiduelles fréquentielles pour former au moins une composante résiduelle A. Ainsi, dans ce cas, le signal audio codé comporte en outre cette composante résiduelle A quantifiée par des moyens de quantification 29e.

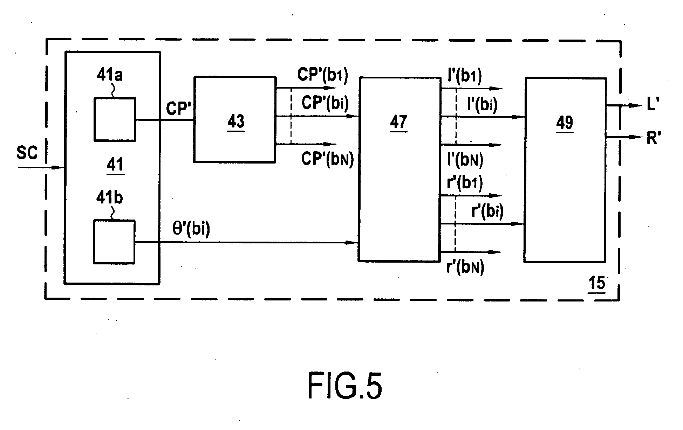

La figure 5 est une vue schématique d'un décodeur 15 comportant des moyens d'extraction 41, des moyens de décomposition de décodage 43, des moyens de transformation inverse 47, et des moyens de combinaison de décodage 49.

La figure 5 illustre également les principales étapes du procédé de décodage selon l'invention.

Ainsi, lorsque le décodeur 15 reçoit un signal audio codé SC, les moyens d'extraction 41 procèdent à l'extraction d'une composante principale décodée CP' par des moyens de décodage audio 41a et au moins un paramètre de transformation décodé $\theta(b_i)$ par des moyens de déquantification 41b.

Les moyens de décomposition de décodage 43 sont destinés à décomposer la composante principale décodée CP' en des sous-composantes principales fréquentielles décodées CP'$(b_1)$,..., CP'$(b_N)$.

Les moyens de transformation inverse 47 sont destinés à transformer les sous-composantes principales fréquentielles décodées CP'$(b_1)$,..., CP'$(b_N)$ en une pluralité de sous-bandes fréquentielles décodées l' $(b_1)$,..., l'$(b_N)$ et r'$(b_1)$,..., r'$(b_N)$.

Finalement, les moyens de combinaison de décodage 49 sont destinés à combiner les sous-bandes fréquentielles décodées pour former au moins deux canaux décodés L' et R' correspondant aux deux canaux L et R issus du signal audio multi-canal original.

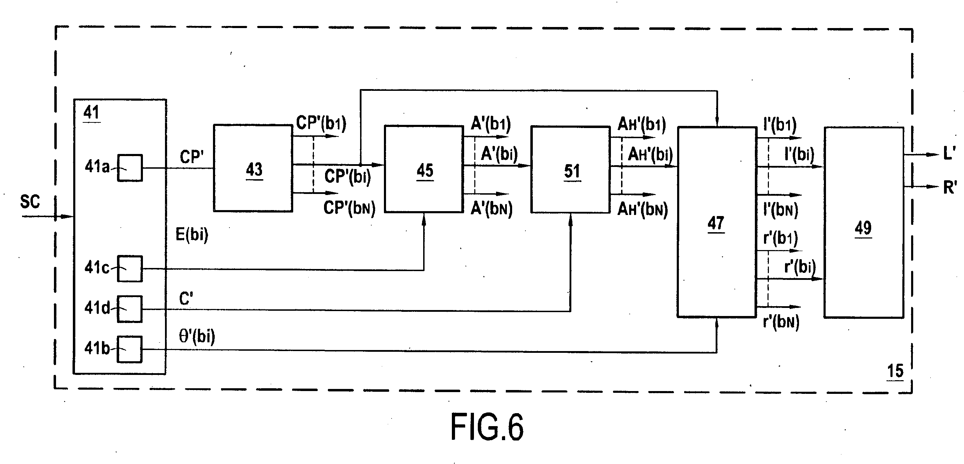

La figure 6 est une variante montrant un décodeur 15 qui se distingue de celui de la figure 5 uniquement par le fait qu'il comporte d'autres moyens de déquantification 41c et 41d en plus de 41b, des moyens de synthèse fréquentielle 45 et des moyens de filtrage 51.

Ainsi, les moyens de déquantification 41c réalisent une quantification inverse d'au moins un paramètre énergétique $E(b_i)$ compris dans le signal audio codé SC et les moyens de synthèse fréquentielle 45 réalisent une synthétisation des sous-composantes résiduelles fréquentielles décodées A'$(b_1)$,..., A'$(b_N)$.

En outre, les moyens de déquantification 41d réalisent une quantification inverse de la valeur de corrélation c compris dans le signal audio codé et les moyens de filtrage 51 réalisent une décorrélation des sous-composantes résiduelles fréquentielles décodées A'$(b_1)$,...,A'$(b_N)$ pour former des sous-composantes résiduelles décorrélées $A_H$'$(b_1)$,..., $A_H$'$(b_N)$.

Les moyens de filtrage 51 réalisent la décorrélation selon un filtrage de décorrélation ou de réverbération en fonction de la valeur de corrélation c.

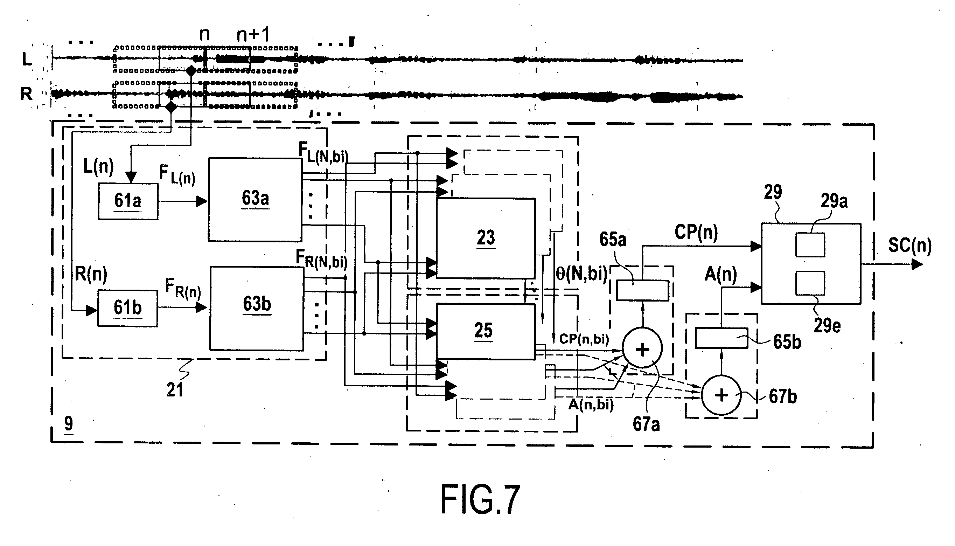

Les figures 7 à 15 à illustrent de manière schématique des modes de réalisations particuliers de la présente invention.

La figure 7 illustre un encodeur 9 pour coder un signal stéréophonique selon l'ACP par sous-bandes de fréquence. Le signal stéréophonique est défini par une succession de trames n, n+1, etc. et comporte deux canaux : un canal Gauche noté L et un canal Droit noté R.

Ainsi, pour une trame déterminée n, les moyens de décomposition 21 décomposent les deux canaux L (n) et R(n) en une pluralité de sous-bandes fréquentielles $F_L(n,b_1)$,...,$F_L(n,b_N)$, $F_R(n,b_1)$,..., $F_R(n,b_N)$.

En effet, les moyens de décomposition 21 comportent des moyens de transformée de Fourier à court terme (TFCT) 61a et 61b et des modules de fenêtrage fréquentiel 63a et 63b permettant de regrouper les coefficients de la transformée de Fourier à court terme en sous-bandes.

Ainsi, une transformée de Fourier à court terme est appliquée à chacun des canaux L(n) et R(n) d'entrée. Ces canaux exprimés dans le domaine fréquentiel sont alors fenêtrés en fréquence par les modules de fenêtrage 63a et 63b selon N bandes définies suivant une échelle perceptuelle équivalente aux bandes critiques.

La matrice de covariance peut alors être calculée par les moyens de calcul 23 pour chaque trame n de signal analysée et pour chaque sous-bande de fréquence $b_i$. Les valeurs propres $\lambda_1(n, b_i)$ et $\lambda_2(n, b_i)$ du signal stéréophonique sont alors estimées pour chaque trame n et chaque sous-bande $b_i$, permettant le calcul du paramètre de transformation ou angle de rotation $\theta(n,b_i)$.

Cet angle de rotation $\theta(n,b_i)$ correspond à la position de la source dominante à la trame n, pour la sous-bande $b_i$ et permet alors aux moyens de rotation ou de transformation 25 de réaliser une rotation des données par sous-bande de fréquence pour déterminer une composante principale fréquentielle CP(n, $b_i$) et une composante résiduelle (ou d'ambiance) fréquentielle A (n, $b_i$). Les énergies des composantes CP(n, $b_i$) et A(n, $b_i$) sont proportionnelles aux valeurs propres $\lambda_1$ et $\lambda_2$ telles que: $\lambda_1 > \lambda_2$. Par conséquent, le signal A(b) a une énergie beaucoup plus faible que celle du signal CP(b).

Les moyens de combinaison 27 combinent les sous-composantes principales fréquentielles CP(n, $b_1$),..., CP(n, $b_N$) pour former une unique composante principale CP(n).

En effet, ces moyens de combinaison 27 comportent des moyens de TFCT inverse 65a et des moyens d'addition 67a. La somme par les moyens d'addition 67a de ces composantes fréquentielles à bande limitée CP (n, $b_i$) permet alors d'obtenir la composante principale CP(n) pleine bande dans le domaine fréquentiel. La TFCT inverse de la composante CP(n) produit une composante temporelle pleine bande.

L'encodeur 9 selon cet exemple comporte d'autres moyens de combinaison 28 comprenant aussi d'autres moyens de TFCT inverse 65b et d'autres moyens d'addition 67b permettant de réaliser la TFCT inverse de la somme des composantes A(n, $b_i$).

On notera que la composante principale CP(n) contient la somme des sources sonores dominantes et la partie des composantes d'ambiance qui coïncide spatialement avec ces sources dominantes présentes dans les signaux originaux. La composante résiduelle A(n) correspond à la somme des sources sonores secondaires, qui se recouvrent spectralement avec les sources dominantes, et des autres composantes d'ambiances.

Finalement, les moyens de définition 29 définissent un flux audio ou un signal audio codé SC(n) représentant le signal audio stéréophonique. Selon cet exemple, les moyens de définition 29 comportent des moyens de codage audio monophonique 29a pour coder la composante principale CP(n), des moyens de codage audio 29e de la composante résiduelle A(n) et des moyens de quantification des paramètres de transformation (non représenté).

L'encodage du signal stéréophonique consiste alors à coder le signal CP(n) par un codeur audio monophonique 29a traditionnel (par exemple le codeur MPEG-1 Layer III ou Advanced Audio Coding), à quantifier les angles de rotations $\theta(n, b_i)$ calculés pour chaque sous-bande et à réaliser un codage paramétrique du signal A(n).

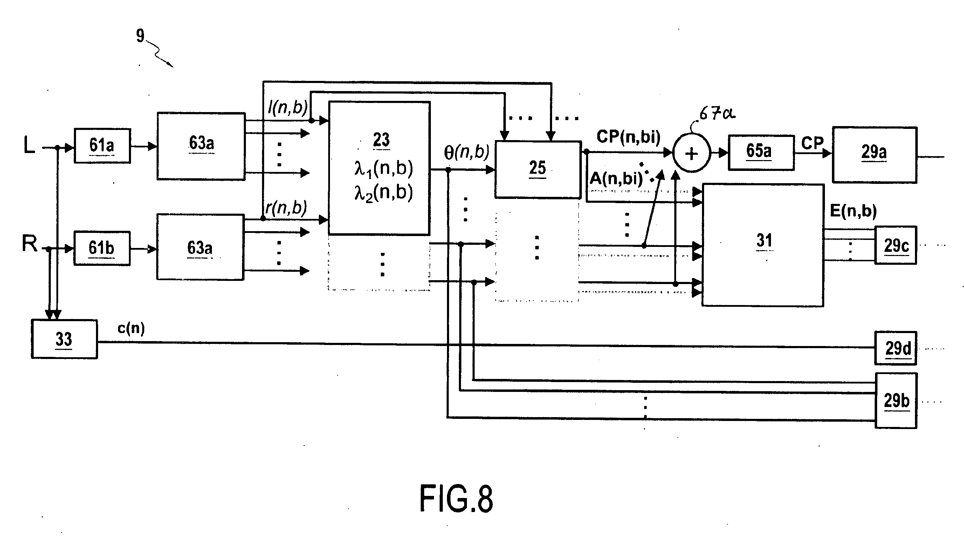

La figure 8 illustre une variante qui se distingue de la figure 7 par le fait que les autres moyens de combinaison 28 sont remplacés par des moyens d'analyse fréquentielle 31 qui réalisent un codage paramétrique des composantes résiduelles fréquentielle $A(n, b_i)$.

Ce codage paramétrique consiste à extraire les différences d'énergie par sous-bande de fréquence $E(n, b_i)$ entre le signal $A(n, b_i)$ et le signal $CP(n, b_i)$.

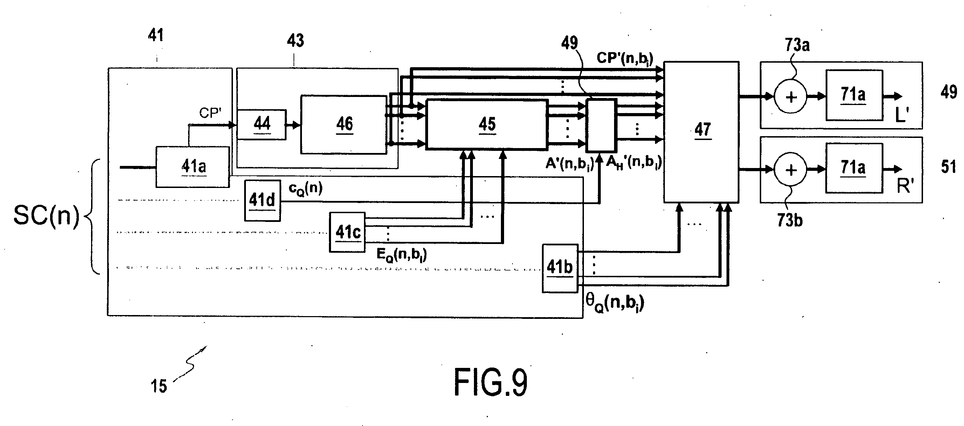

En effet, l'objet du codage paramétrique est de pouvoir synthétiser au décodage (voir figure 9) des composantes résiduelles $A'(n, b_i)$ à partir du signal $CP'(n)$ décodé par un décodeur audio monophonique 41a, et des paramètres énergétiques $E(n, b_i)$ quantifiés et transmis par l'encodeur 9.

En outre, l'encodeur 9 selon cet exemple comporte des moyens d'analyse de corrélation 33 pour déterminer une valeur de corrélation c(n) du signal original à la trame n.

Finalement, la composante principale ou signal CP(n) est codé comme précédemment par un codeur audio monophonique 29a. Par ailleurs, les paramètres énergétiques $E(n, b_i)$, les angles de rotations $\theta(n, b_i)$ pour chaque sous-bande et la valeur de corrélation c(n) sont quantifiés par les moyens de quantification 29c, 29b et 29d respectivement et sont transmis au décodeur 15 de manière à réaliser l'ACP inverse.

La figure 9 est une vue schématique d'un décodeur 15 pour décoder un signal audio codé SC(n) comprenant un flux audio et des paramètres de décodage en un signal stéréophonique basé sur une ACP inverse par sous-bandes de fréquence.

Ainsi, à la réception du signal audio codé SC(n), le décodeur 15 comporte des moyens de décodage monophonique 41a pour extraire une composante principale décodée CP'(n) et des moyens de déquantification 41b, 41c et 41d pour extraire les paramètres de transformation ou angles de rotation $\theta_Q(n, b_i)$, les paramètres d'énergie $E_Q(n, b_i)$, et la valeur de corrélation $c_Q(n)$.

Les moyens de décomposition de décodage 43 décomposent la composante principale décodée CP'(n) par un fenêtrage fréquentiel à N bandes, en des sous-composantes principales fréquentielles décodées.

En outre, une composante résiduelle $A'(n, b_i)$ peut être synthétisée par des moyens de synthèse fréquentielle 45 à partir du flux audio décodé $CP'(n, b_i)$, mis en forme spectralement par les paramètres d'énergie $E_Q(n, b)$ déquantifiés.

Le décodeur 15 réalise alors l'opération inverse du codeur puisque l'ACP est une transformation linéaire. L'ACP inverse est réalisée par les moyens de transformation inverse, en multipliant les signaux $CP'(n, b_i)$ et $A'_H(n, b_i)$ par la matrice transposée de la matrice de rotation utilisée à l'encodage. Cela est rendu possible grâce à la quantification inverse des angles de rotation par sous-bande de fréquence.

On notera que les signaux $A'_H(n, b_i)$ correspondent aux composantes résiduelles $A'(n, b_i)$ décorellées par des moyens de filtrage 49 de décorrélation ou de réverbération.

En effet, dues aux propriétés de décorrélation de l'ACP, l'utilisation d'un filtre de décorrélation ou de réverbération est souhaitable pour synthétiser une composante $A'_H(n, b_i)$ décorrélée du signal $A'(n, b_i)$ et par suite du signal $CP'(n, b_i)$.

Les moyens de filtrage 49 comportent un filtre dont la réponse impulsionnelle h(n) est fonction des caractéristiques du signal original. En effet, l'analyse temporelle de la corrélation du signal original à la trame n détermine la valeur de corrélation c(n) qui correspond au choix du filtre à utiliser au décodage. Par défaut, c(n) impose la réponse impulsionnelle d'un filtre passe-tout à phase aléatoire qui réduit fortement l'inter-corrélation des signaux $A'(n, b_i)$ et $A'_H(n, b_i)$. Si l'analyse temporelle du signal stéréo révèle la présence de réverbération, c(n) impose l'utilisation, par exemple, d'un bruit blanc gaussien d'énergie décroissante de manière à réverbérer le contenu du signal $A'(n, b_i)$.

Finalement, des moyens de combinaison 49 et 51 comportant des moyens de TFCT inverses 71a et 71b et des moyens d'addition 73a et 73b combinent les sous-bandes fréquentielles décodées pour former deux composantes décodées L'(n) et R'(n) correspondant aux deux composantes L(n) et R(n) issus du signal audio stéréophonique d'origine.

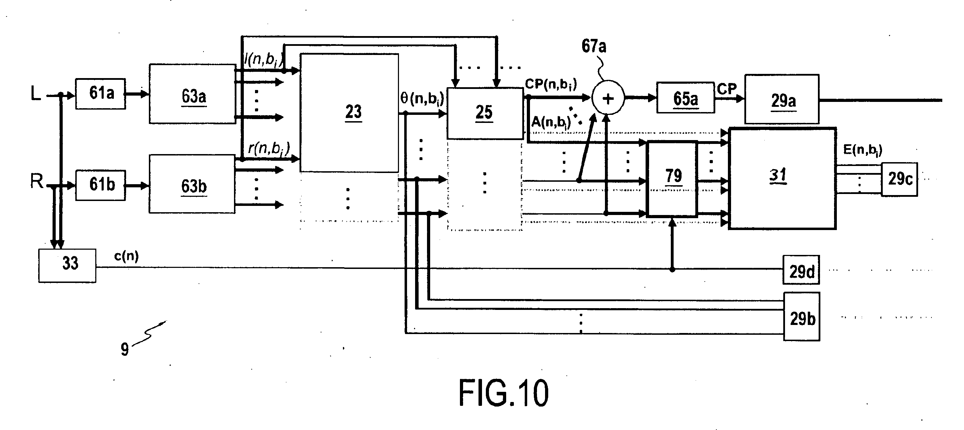

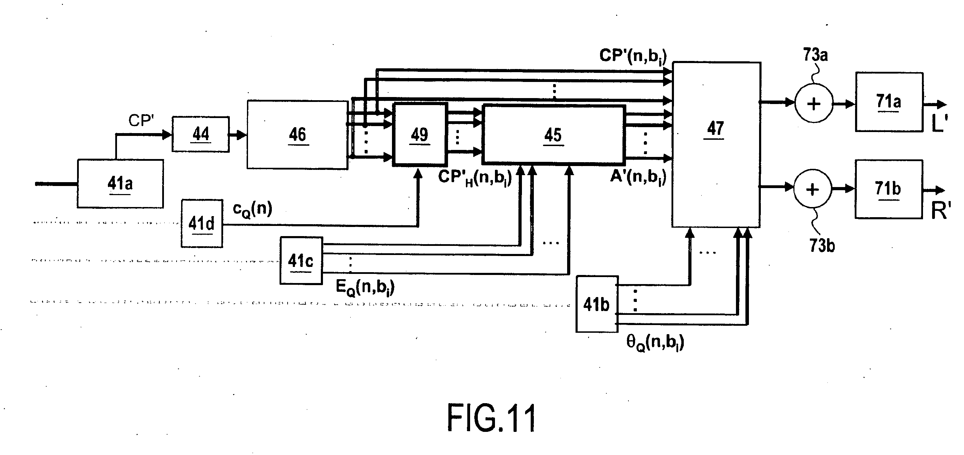

Les figures 10 et 11 sont des variantes des figures 7 à 9, illustrant un encodeur 9 et un décodeur 15 correspondant.

En effet, une variante du procédé de codage décrit ci-avant peut être envisagé si le filtrage modifie l'amplitude du signal filtré, ce qui peut être le cas avec un filtre de réverbération notamment.

Ainsi, l'encodeur 9 de la figure 10 comporte des moyens de filtrage 79 pour filtrer les composantes principales $CP(n, b_i)$ en formant des signaux filtrés $CP_H(n, b_i)$.

En outre, le décodeur 15 comporte des moyens de filtrage 49 similaires à ceux de la figure 9.

Dans ce cas, le filtrage est utilisé au décodage et à l'encodage avant d'estimer les paramètres d'énergie $E(n,b_i)$ entre les signaux $CP_H(n, b_i)$ et $A(n, b_i)$. Les paramètres d'énergie $E(n,b_i)$ caractérisent alors les différences d'énergie par sous-bande entre les signaux $CP_H(n, b_i)$ et $A(n, b_i)$.

De cette façon, au décodage (voir figure 11), une composante résiduelle $A'(n,b_i)$ peut être synthétisée à partir du filtrage du signal décodé $CP'_H(n, b_i)$ mis en forme spectralement par les paramètres énergétiques $E_Q(n,b)$ déquantifiés.

Par ailleurs, selon une autre variante, les énergies transmises $E_Q(n,b)$ peuvent correspondre aux énergies par sous-bande de la composante résiduelle $A(n, b_i)$ et sont donc appliquées à la composante principale décodée pour synthétiser un signal d'ambiance ou résiduel $A'(n)$ avant l'ACP inverse.

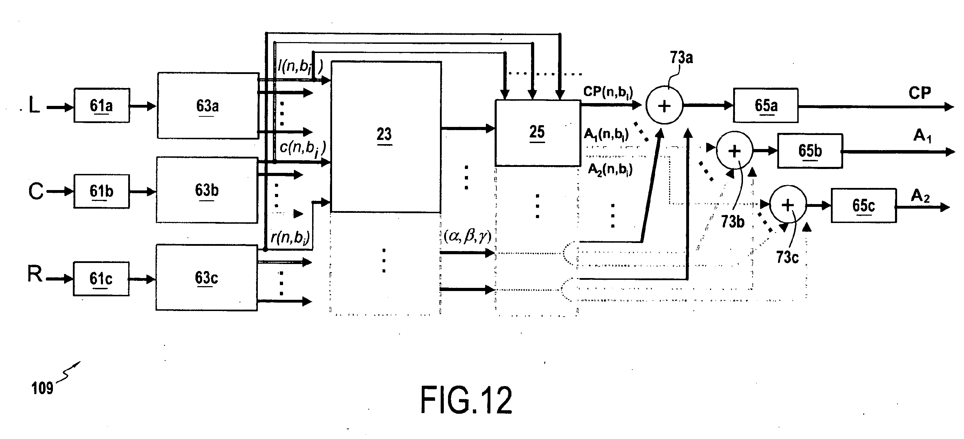

La figure 12 illustre un encodeur 109 d'un signal multi-canal appliquant l'ACP à trois canaux. En effet, cet encodeur utilise une ACP tridimensionnelle du signal à trois canaux paramétrés par les angles d'Euler $(\alpha,\beta,\gamma)_b$ estimés pour chaque sous-bande b.

L'encodeur 109 se distingue de celui de la figure 7 par le fait qu'il comporte trois moyens de transformée de Fourier à court (TFCT) 61a, 61b et 61c ainsi que trois modules de fenêtrage fréquentiel 63a, 63b et 63c.

En outre, il comporte trois moyens de TFCT inverses 65a, 65b et 65c ainsi que trois moyens d'addition 73a, 73b et 73c.

L'ACP est alors appliquée à un triplet de signaux L, C et R. L'ACP tridimensionnelle 3D est alors réalisée par une rotation 3D des données paramétrée par les angles d'Euler $(\alpha,\beta,\gamma)$. Comme pour le cas stéréophonique, ces angles de rotations sont estimés pour chaque sous-bande de fréquence à partir de la covariance et des valeurs propres du signal multi-canal original.

Le signal CP contient la somme des sources sonores dominantes et la partie des composantes d'ambiance qui coïncide spatialement avec ces sources présentes dans les signaux originaux.

La somme des sources sonores secondaires, qui se recouvrent spectralement avec les sources dominantes, et des autres composantes d'ambiances se répartie proportionnellement aux valeurs propres $\lambda_2$ et $\lambda_3$ dans les signaux $A_1$ et $A_2$ qui sont nettement moins énergétiques que le signal CP puisque : $\lambda_1 > \lambda_2 > \lambda_3$.

Ainsi, le procédé de codage appliqué aux signaux stéréophoniques peut être étendu au cas des signaux multi-canal $C_1,...,C_6$ de format 5.1 comportant les canaux suivants : Gauche (Left) L, Central (Center) C, Droit (Right) R, Arrière Gauche (Left surround) Ls, Arrière Droit (Right surround) Rs, et Basses Fréquences (Low Frequency Effect) LFE.

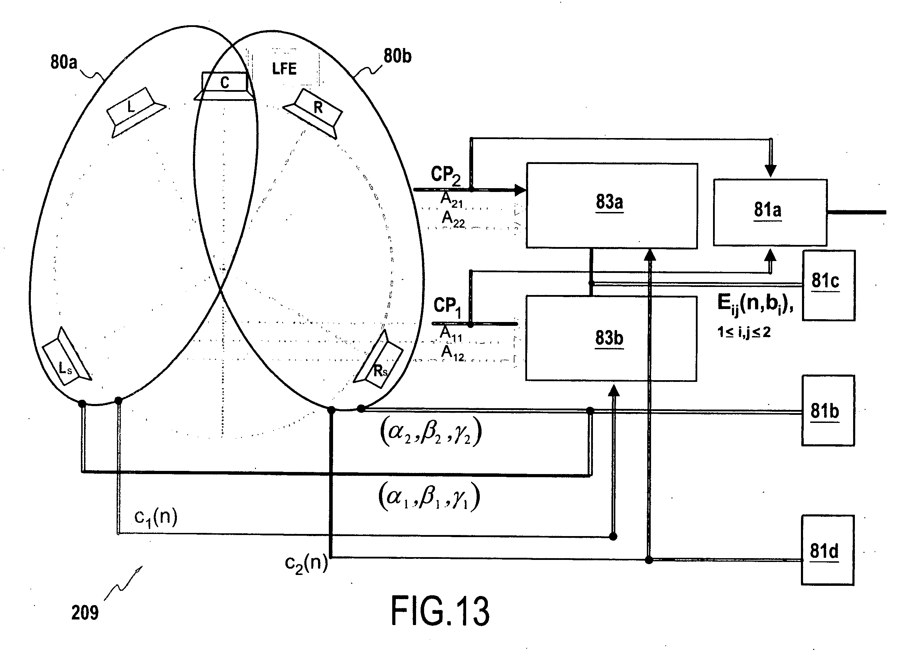

En effet, la figure 13 est une vue schématique illustrant un encodeur 209 d'un signal multi-canal de format 5.1. Selon cet exemple, le codage audio paramétrique des signaux 5.1 est basé sur deux ACP tridimensionnelles des signaux séparés selon le plan médian.

Ainsi, cet encodeur 209 permet de réaliser une première $ACP_1$ du triplet 80a de signaux (L, C, $L_s$) selon l'encodeur 109 de la figure 12 et de même, une seconde $ACP_2$ du triplet 80b de signaux (R, C, $R_s$) selon l'encodeur 109.

Ainsi, le couple de composantes principales $(CP_1, CP_2)$ peut être considéré comme un signal stéréophonique (L, R) spatialement cohérent avec le signal multi-canal original.

Il convient de préciser que le signal LFE peut être codé indépendamment des autres signaux puisque le contenu basse-fréquence à caractère discret de ce canal n'est que peu sensible à la réduction des redondances inter-canal.

L'encodage selon la figure 13 s'adapte aux contraintes de débit du réseau de transmission en transmettant un signal stéréophonique codé par un codeur audio stéréophonique 81a accompagné de paramètres quantifiés par des moyens de quantification 81b, 81c et 81d définis pour chaque trame n et chaque sous-bande $b_i$ de fréquence.

Ainsi, le codeur audio stéréophonique 81a permet de coder le couple de composantes principales $(CP_1, CP_2)$. Les moyens de quantification 81b permettent de quantifier les angles d'Euler $(\alpha,\beta,\gamma)$ utiles aux ACP de chaque triplet de signaux.

Les moyens de quantification 81d permettent de quantifier les valeurs $c_1(n)$ et $c_2(n)$ déterminant le choix du filtre à utiliser pour chaque triplet de signaux.

En outre, des moyens de filtrage et d'analyse fréquentielle 83a et 83b permettent de déterminer des paramètres ou différences d'énergies par sous-bande de fréquence $E_{ij}(n,b)$ $(1 \leq i,j \leq 2)$ entre les signaux $CP_1$ et $A_{11}$, $A_{12}$ ainsi que les signaux $CP_2$ et $A_{21}$, $A_{22}$ respectivement.

En variante, les paramètres d'énergie correspondent aux énergies par sous-bande des signaux $A_{11}$, $A_{12}$ et $A_{21}$, $A_{22}$.

Finalement, les paramètres d'énergie $E_{ij}(n,b)$ peuvent être quantifiés par les moyens de quantification 81c.

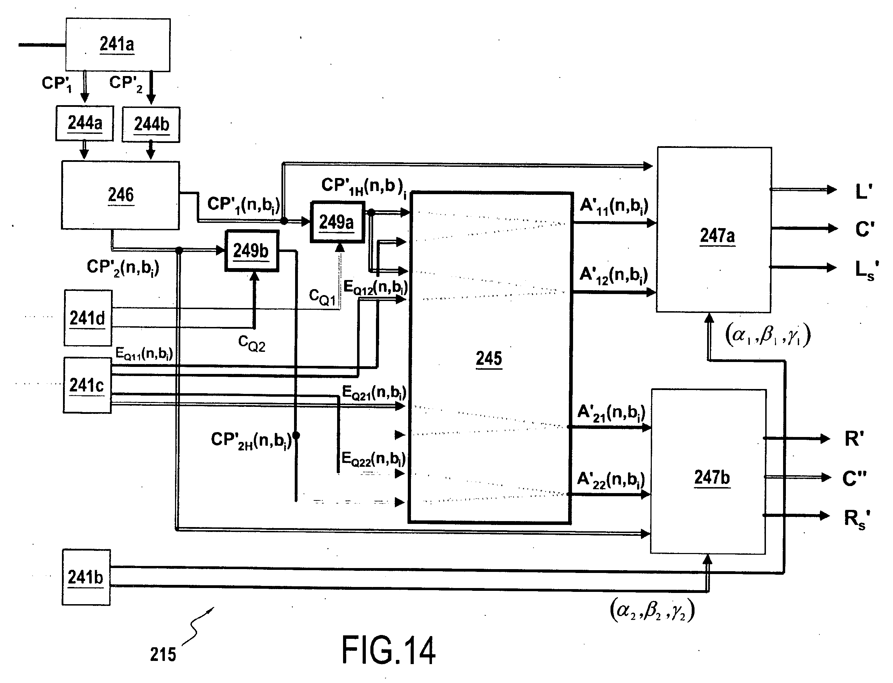

La figure 14 illustre un décodeur 215 d'un signal codé par l'encodeur 209 de la figure 13.

Ce décodeur 215 comporte des moyens similaires aux moyens du décodeur 15 des figures précédentes.

En outre, le décodeur 215 comporte des moyens de décodage stéréophonique 241a et des moyens de déquantification 241b, 241c et 24d.

Ils comportent également des moyens de transformé de Fourier à court terme (TFCT) 244a et 244b et des modules de fenêtrage fréquentiel 246.

En outre, le décodeur 215 comporte des moyens de filtrages 249a et 249b, des moyens de synthèse fréquentielle 245 et des moyens de transformation inverses 247a (ACP$_1^{-1}$) et 247b (ACP$_2^{-1}$).

Le décodage consiste à traiter les composantes principales décodées et filtrées par les moyens de filtrages 249a et 249b qui peuvent voir leur réponse impulsionnelle basculer d'un filtre passe-tout à phase aléatoire à un filtre de réverbération dont la réponse impulsionnelle peut prendre la forme d'un bruit blanc à enveloppe décroissante suivant les valeurs de corrélation C$_{Q1}$ et C$_{Q2}$.

Ensuite, les moyens de synthèse fréquentielle 245 réalisent une synthèse dans le domaine fréquentiel paramétrée par les différences d'énergie extraites à l'encodage entre les composantes issues des deux ACP$_1$ et ACP$_2$ en 3D de la figure 13 (ou l'énergie des signaux d'ambiance par sous-bande).

Une fois les composantes ambiances synthétisées, les ACP 3D inverses sont réalisées par les moyens de transformation inverses 247a (ACP$_1^{-1}$) et 247b (ACP$_2^{-1}$) avec les transposées des matrices de rotation 3D paramétrées par les angles d'Euler déquantifiés pour former les couples de signaux (L', C', L's) et (R', C", R's).

On notera que, les signaux C' et C" peuvent être sommés pour former un signal C''' donné par

$$C''' = \frac{C' + C''}{2}$$ pour générer un canal central le plus proche possible du signal C original. Il est aussi possible de choisir l'un des deux signaux C' et C".

Le signal LFE est alors soit décodé indépendamment (par les moyens de filtrage 249a) soit obtenu par un filtrage passe-bas (fréquence de coupure à 120 Hz) du canal central décodé C''' (par les moyens de filtrage 249a) ou éventuellement par synthèse fréquentielle à partir du signal central décodé C''' et de paramètres énergétiques extraits à l'encodage entre le signal C et le signal LFE.

La technique de codage ainsi décrite assure une compatibilité des systèmes de diffusion 5.1 avec les systèmes de diffusion stéréophoniques puisque les composantes principales décodées (CP'$_1$ et CP'$_2$) constituent un signal stéréophonique spatialement cohérent avec le signal 5.1 original.

La compatibilité avec les systèmes de diffusion monophonique est également possible en réalisant une ACP bidimensionnelle (ACP 2D) des deux composantes principales extraites à l'encodage par les deux ACP 3D.

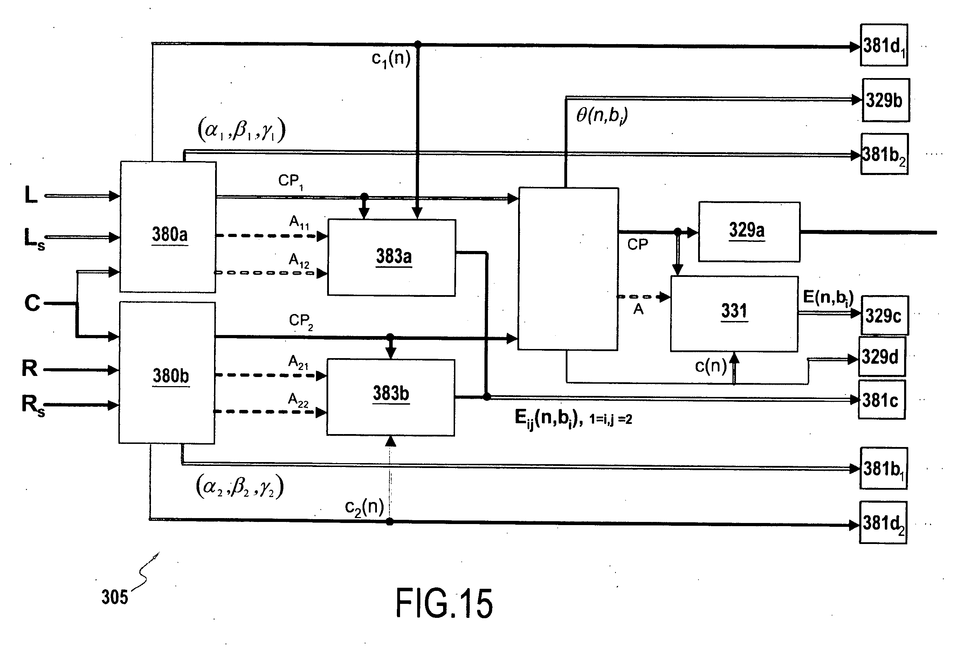

En effet, la figure 15 est une vue schématique d'un encodeur 305 comportant deux moyens ACP tridimensionnelles 380a (ACP$_1$) et 380b (ACP$_1$).

Ainsi, l'encodeur 305 réalise un codage audio paramétrique des signaux 5.1 basé sur les deux moyens ACP tridimensionnelles 380a (ACP$_1$) et 380b (ACP$_1$) selon des signaux séparés selon le plan médian.

Ceci est suivi d'une ACP bidimensionnelle par les moyens ACP bidimensionnelle des composantes principales du signal 5.1 original.

Ainsi l'encodeur 305 réalise le codage audio monophonique de la composante CP par les moyens de codage monophoniques 329a.

En outre, des moyens de filtrage et d'analyse fréquentielle 383a et 383b permettent de déterminer des paramètres ou différences d'énergies E$_{ij}$(n,b$_i$) (1 ≤ i,j ≤ 2) pour chaque trame n et chaque sous-bande de fréquence b$_i$, entre les signaux CP$_1$ et A$_{11}$, A$_{12}$ ainsi que les signaux CP$_2$ et A$_{21}$, A$_{22}$. respectivement. En variante, les paramètres d'énergie correspondent aux énergies par sous-bande des signaux A$_{11}$, A$_{12}$ et A$_{21}$, A$_{22}$).

Ces paramètres d'énergie E$_{ij}$(n,b) peuvent être quantifiés par les moyens de quantification 381c.

Les moyens de quantification 381b1 et 381b2 permettent de quantifier les angles d'Euler (α$_1$, β$_1$, γ$_1$) et (α$_2$, β$_2$, γ$_2$) utiles aux ACP de chaque triplet de signaux.

Les moyens de quantification 81d1, 81d2 et 329d permettent de quantifier les valeurs c$_1$(n), c$_2$(n) et c(n) respectivement, déterminant le choix du filtre à utiliser pour générer les composantes ambiances décorrélées des composantes principales.

Les moyens de quantification 329b permettent de quantifier l'angle de rotation utile à l'ACP 2D des composantes principales issues des moyens de transformation 325 (ACP 2D).

En outre, les différences d'énergies E(n, b$_i$) pour chaque trame n et chaque sous-bande de fréquence b entre les signaux CP et A (ou les énergies par sous-bande du signal A) issues des moyens de filtrage et analyse fréquentielle 331 peuvent être quantifiées par les moyens de quantification 329c.

Ainsi, le décodeur associé peut directement décoder le flux en un signal monophonique CP'. En utilisant les paramètres déquantifiés appropriés (E$_Q$(n,b), c$_Q$(n) et θ(n,b)), le décodeur peut générer une composante ambiance A' et réaliser l'ACP 2D inverse. En suite, le décodeur peut délivrer le signal stéréophonique CP'$_1$, CP'$_2$. De la même manière, en utilisant les paramètres déquantifiés appropriés (E$_{ijQ}$(n,b) pour 1 ≤ i,j ≤ 2, C$_{1Q}$(n), C$_{2Q}$(n), (α$_1$,β$_1$,γ$_1$)$_{(n,b)}$ et (α$_2$,β$_2$,γ$_2$)$_{(n,b)}$), le décodeur peut synthétiser les composantes ambiances nécessaires pour réaliser les deux ACP 3D inverses et ainsi reconstruire le signal 5.1.

La méthode de codage des signaux audio de type 5.1 proposée se base sur une séparation des signaux selon le plan médian (plan vertical qui sépare la gauche et la droite de l'auditeur) qui permet les ACP 3D des deux triplets de signaux (L, C, Ls) et (R, C, Rs). Il convient de préciser qu'une séparation avant/arrière des signaux peut également être envisageable. Dans ce cas, une ACP 3D du triplet de signaux (L, C, R: scène frontale) et une ACP 2D de la paire de signaux (Ls, Rs: scène arrière) peuvent être employées. La technique de codage des signaux issus de ces ACP suit alors le même principe que celui décrit précédemment. Néanmoins dans ce cas la compatibilité avec les systèmes de diffusion stéréophoniques peut être perdue.

Une multitude de configurations peuvent être envisagées à partir de l'association des modules ACP 2D et/ou ACP 3D. L'exemple de la figure 15 ne constitue qu'une de ces nombreuses configurations possibles.

En effet, le codage des signaux audio de type 5.1 peut par exemple être réalisé avec trois ACP 2D des couples (L, Ls), (C, LFE), (R, Rs) suivies d'une ACP 3D des trois composantes principales résultantes ($CP_1$, $CP_2$, $CP_3$).

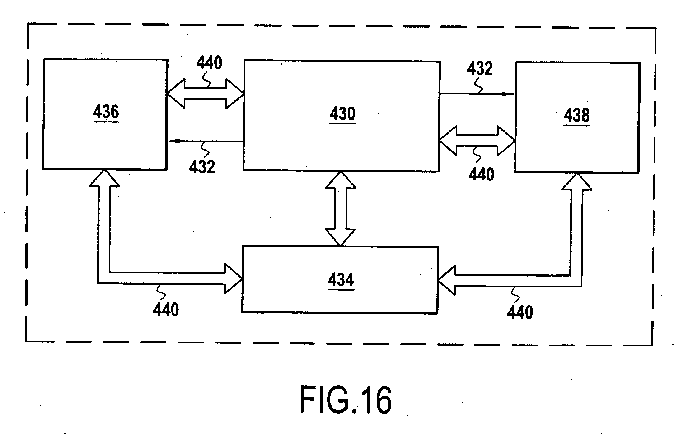

La figure 16 illustre très schématiquement un système informatique mettant en ouvre l'encodeur ou le décodeur selon les figures 1 à 15. Ce système informatique comporte de manière classique une unité centrale de traitement 430 commandant par des signaux 432 une mémoire 434, une unité d'entrée 436 et une unité de sortie 438. Tous les éléments sont raccordés entre eux par des bus de données 440.

De plus, ce système informatique peut être utilisé pour exécuter un programme d'ordinateur comportant des instructions de codes de programme pour la mise en oeuvre du procédé de codage ou de décodage selon l'invention.

En effet, l'invention vise aussi un produit programme d'ordinateur téléchargeable depuis un réseau de communication comprenant des instructions de codes de programme pour l'exécution des étapes du procédé de codage ou de décodage selon l'invention lorsqu'il est exécuté sur un ordinateur. Ce programme d'ordinateur peut être stocké sur un support lisible par ordinateur et peut être exécutable par un microprocesseur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

Ainsi, L'ACP réalisée par sous-bandes de fréquence selon l'invention permet de compacter d'avantage l'énergie des composantes originales comparée à une ACP réalisée dans le domaine temporel. L'énergie de la composante ambiance A (respectivement CP) est plus faible (respectivement grande) avec une ACP réalisée par sous-bandes de fréquence.

Par ailleurs, la méthode peut être étendue au codage de divers types de signaux audio multicanaux (formats audio 2D et 3D).

En outre, la méthode de codage selon l'invention est graduée (scalable en anglais) en nombre de canaux décodés. Par exemple, le codage d'un signal au format 5.1 permet également le décodage en un signal stéréophonique de façon à assurer la compatibilité avec différents systèmes de restitution.

Les domaines d'application de la présente invention, sont les transmissions audio-numériques sur divers réseaux de transmission à différents débits puisque la méthode proposée permet d'adapter le débit de codage en fonction du réseau ou de la qualité souhaité.

De plus, ce procédé est généralisable au codage audio multi-canal avec un nombre de signaux plus grand. En effet, la méthode proposée est par nature généralisable et applicable à de nombreux formats audio 2D et 3D (formats 6.1, 7.1, ambisonique, wave field synthesis, etc.).

Un exemple d'application particulier est la compression, transmission puis restitution d'un signal audio multi-canal sur internet suite à la demande/achat d'un internaute (auditeur). Ce service est d'ailleurs couramment appelé "audio on demand". La méthode proposée permet alors d'encoder un signal multi-canal (stéréophonique ou de type 5.1) à un débit supporté par le réseau internet reliant l'auditeur au serveur. Ainsi, l'auditeur peut écouter la scène sonore décodée au format souhaité sur son système de diffusion multi-canal. Dans le cas où le signal à transmettre est de type 5.1 mais que l'utilisateur ne possède pas de système de restitution multi-canal, la transmission peut alors se limiter aux composantes principales du signal multi-canal de départ ; et par suite, le décodeur délivre un signal avec moins de canaux comme un signal stéréophonique par exemple.

## Revendications

1. Procédé de codage par analyse en composante principale (ACP) d'un signal audio multi-canal ($C_1$,..., $C_M$), **caractérisé en ce qu'**il comporte les étapes suivantes :

   - décomposer au moins deux canaux (L, R) dudit signal audio en une pluralité de sous-bandes fréquentielles ($l(b_1)$,..., $l(b_N)$, $r(b_1)$,..., $r(b_N)$),
   - calculer au moins un paramètre de transformation ($\theta(b_1)$,..., $\theta(b_N)$) en fonction d'au moins une partie de ladite pluralité de sous-bandes fréquentielles,
   - transformer au moins une partie de ladite pluralité de sous-bandes fréquentielles en une pluralité de sous-composantes fréquentielles en fonction dudit au moins un paramètre de transformation $(\theta(b_1),..., \theta(b_N))$, ladite pluralité de sous-composantes fréquentielles comportant des sous-composantes principales fréquentielles $(CP(b_1),..., CP(b_N))$,

- combiner au moins une partie desdites sous-composantes principales fréquentielles $(CP(b_1),..., CP(bN))$ pour former une composante principale $(CP)$, et

- définir un signal audio codé $(SC)$ représentant ledit signal audio multi-canal $(C_1,...,C_M)$, ledit signal audio codé $(SC)$ comportant ladite composante principale $(CP)$ et ledit au moins un paramètre de transformation $(\theta(b_1),..., \theta(b_N))$.

**2.** Procédé selon la revendication 1, **caractérisé en ce que** ladite pluralité de sous-composantes fréquentielles comporte en outre des sous-composantes résiduelles fréquentielles $(A(b_1),..., A(b_N))$.

**3.** Procédé selon la revendication 2, **caractérisé en ce qu'**il comporte une formation d'un ensemble de paramètres énergétiques $(E(b_1),..., E(b_N))$ en fonction des sous-composantes résiduelles fréquentielles $(A(b_1),..., A(b_N))$.

**4.** Procédé selon la revendication 3, **caractérisé en ce que** l'ensemble de paramètres énergétiques $(E(b_1),..., E(b_N))$ est formé par une extraction des différences d'énergie par sous-bandes de fréquence entre les sous-composantes principales fréquentielles $(CP(b_1),..., CP(b_N))$ et les sous-composantes résiduelles fréquentielles $(A(b_1),..., A(b_N))$.

**5.** Procédé selon la revendication 3, **caractérisé en ce que** l'ensemble de paramètres énergétiques $(E(b_1),..., E(b_N))$ correspond aux énergies des sous-composantes résiduelles fréquentielles $(A(b_1),..., A(b_N))$.

**6.** Procédé selon la revendication 3 à 5, **caractérisé en ce qu'**il comporte un filtrage des sous-composantes principales fréquentielles avant l'extraction de l'ensemble de paramètres énergétiques $(E(b_1),..., E(b_N))$.

**7.** Procédé selon l'une quelconque des revendications 3 à 6, **caractérisé en ce que** le signal audio codé $(SC)$ comporte en outre au moins un paramètre énergétique parmi ledit ensemble de paramètres énergétiques $(E(b_1),..., E(b_N))$.

**8.** Procédé selon l'une quelconque des revendications 2 à 7, **caractérisé en ce qu'**il comporte une combinaison d'au moins une partie desdites sous-composantes résiduelles fréquentielles pour former au moins une composante résiduelle $(A)$ et **en ce que** le signal audio codé comporte en outre ladite au moins une composante résiduelle $(A)$.

**9.** Procédé selon l'une quelconque des revendications 1 à 8, **caractérisé en ce qu'**il comporte une analyse de corrélation entre lesdits au moins deux canaux $(L, R)$ pour déterminer une valeur de corrélation $(c)$ correspondante, et **en ce que** ledit signal audio codé comporte en outre ladite valeur de corrélation $(c)$.

**10.** Procédé selon l'une quelconque des revendications 1 à 9, **caractérisé en ce que** ladite pluralité de sous-bandes fréquentielles $(l(b_1),... l(b_N), r(b_1),..., r(b_N))$ est définie suivant une échelle perceptuelle.

**11.** Procédé selon la revendication 7, **caractérisé en ce que** la définition dudit signal audio codé comporte un codage audio de ladite composante principale $(CP)$ et une quantification dudit au moins un paramètre de transformation et/ou une quantification dudit au moins un paramètre énergétique E, et/ou une quantification de ladite au moins une composante résiduelle $(A)$.

**12.** Procédé selon l'une quelconque des revendications 1 à 11, **caractérisé en ce que** ledit signal audio est défini par une succession de trames de sorte que lesdits au moins deux canaux $(L, R)$ sont définies pour chaque trame n.

**13.** Procédé selon l'une quelconque des revendications 1 à 12, **caractérisé en ce que** le signal audio multi-canal $(C_1,...,C_M)$ est un signal stéréophonique.

**14.** Procédé selon l'une quelconque des revendications 1 à 12, **caractérisé en ce que** le signal audio multi-canal $(C_1,...,C_M)$ est un signal audio au format 5.1 comportant les canaux suivants : Gauche $(L)$, Central $(C)$, Droit $(R)$, Arrière Gauche $(Ls)$, Arrière Droit $(Rs)$, et Basse Fréquences $(LFE)$.

**15.** Procédé selon la revendication 14, **caractérisé en ce qu'**il comporte la formation d'un premier triplet de signaux comportant les canaux Gauche, Central, et Arrière Gauche $(L, C, Ls)$ et d'un second triplet de signaux comportant les canaux Droit, Central, et Arrière Droit $(R, C, Rs)$ et **en ce que** les premier et second triplets sont utilisés séparément pour former des première et seconde composantes principale $(CP1, CP2)$ selon des paramètres de transformation comportant des premiers et seconds angles d'Euler respectivement.

**16.** Procédé de décodage d'un signal de réception comportant un signal audio codé construit selon l'une quelconque des revendications 1 à 15, **caractérisé en ce qu'**il comporte les étapes suivantes :

- recevoir le signal audio codé $(SC)$,

- extraire une composante principale décodée (CP') et au moins un paramètre de transformation décodé,

- décomposer ladite composante principale décodée (CP') en des sous-composantes principales fréquentielles décodées,

- transformer lesdites sous-composantes principales fréquentielles décodées en une pluralité de sous-bandes fréquentielles décodées, et

- combiner les sous-bandes fréquentielles décodées pour former au moins deux canaux décodés (L', R') correspondant auxdits au moins deux canaux (L, R) issus dudit signal audio multi-canal original.

17. Procédé de décodage selon la revendication 16, **caractérisé en ce qu'**il comporte la quantification inverse de paramètres énergétiques $(E(b_1),..., E(b_N))$ compris dans le signal audio codé pour synthétiser des sous-composantes résiduelles fréquentielles décodées $(A'(b_1),..., A'(b_N))$.

18. Procédé de décodage selon la revendication 17, **caractérisé en ce qu'**il comporte une étape de décorrélation des sous-composantes résiduelles fréquentielles décodées $(A'(b_1),..., A'(b_N))$ pour former des sous-composantes résiduelles décorrélées $(A_H'(b_1),..., A_H'(b_N))$.

19. Procédé de décodage selon la revendication 18, **caractérisé en ce que** la décorrélation est réalisée par un filtrage de décorrélation ou de réverbération selon une valeur de corrélation (c) comprise dans le signal audio codé.

20. Encodeur (9) par analyse en composante principale (ACP) d'un signal audio multi-canal $(C_1,...,C_M)$, ledit encodeur (9) étant **caractérisé en ce qu'**il comporte :

    - des moyens de décomposition (21) pour décomposer au moins deux canaux (L, R) dudit signal audio en une pluralité de sous-bandes fréquentielles $(l(b_1),..., l(b_N), r(b_1),..., r(b_N))$,

    - des moyens de calcul (23) pour calculer au moins un paramètre de transformation $(\theta(b_1),..., \theta(b_N))$ en fonction d'au moins une partie de ladite pluralité de sous-bandes fréquentielles,

    - des moyens de transformation (25) pour transformer au moins une partie de ladite pluralité de sous-bandes fréquentielles en une pluralité de sous-composantes fréquentielles en fonction dudit au moins un paramètre de transformation $(\theta(b_1),..., \theta(b_N))$, ladite pluralité de sous-composantes fréquentielles comportant des sous-composantes principales fréquentielles $(CP(b_1),..., CP(b_N))$,

    - des moyens de combinaison (27) pour combiner au moins une partie desdites sous-composantes principales fréquentielles $(CP(b_1),..., CP(b_N))$ afin de former une composante principale (CP), et

    - des moyens de définition (29) pour définir un signal audio codé (SC) représentant ledit signal audio multi-canal $(C_1,...,C_M)$, ledit signal audio codé (SC) comportant ladite composante principale (CP) et ledit au moins un paramètre de transformation $(\theta(b_1),..., \theta(b_N))$.

21. Décodeur (15) d'un signal de réception comportant un signal audio codé (SC) issu d'un signal multi-canal original comprenant au moins deux canaux (L, R), ledit décodeur (15) étant **caractérisé en ce qu'**il comporte :

    - des moyens d'extraction (41) pour extraire une composante principale décodée (CP') et au moins un paramètre de transformation décodé,

    - des moyens de décomposition (43) de décodage pour décomposer ladite composante principale décodée (CP') en des sous-composantes principales fréquentielles décodées,

    - des moyens de transformation inverse (47) pour transformer lesdites sous-composantes principales fréquentielles décodées $(CP'(b_1),..., CP'(b_N))$ en une pluralité de sous-bandes fréquentielles décodées $(l'(b_1),...,l'(b_N))$, et

    - des moyens de combinaison (49) de décodage pour combiner lesdites sous-bandes fréquentielles décodées afin de former au moins deux canaux décodés (L', R') correspondant auxdits au moins deux canaux (L, R) issus dudit signal audio multi-canal original.

22. Système comportant l'encodeur selon la revendication 20 et le décodeur selon la revendication 21.

23. Programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé d'encodage selon au moins l'une des revendications 1 à 15, lorsqu'il est exécuté sur un ordinateur.

24. Programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé de décodage selon au moins l'une des revendications 16 à 19, lorsqu'il est exécuté sur un ordinateur.

**Claims**

1. Method for encoding by principal component analysis (PCA) of a multi-channel audio signal ($C_1$, ..., $C_M$), **characterized in that** it comprises the following steps:

- breaking down at least two channels (L, R) of said audio signal into a plurality of frequency sub-bands ($l(b_1)$, ..., $l(b_N)$, $r(b_1)$, ..., $r(b_N)$),
- computing at least one transformation parameter ($\theta(b_1)$, ..., ($\theta(b_N)$)), as a function of at least one portion of said plurality of frequency sub-bands,
- transforming at least a portion of said plurality of frequency sub-bands into a plurality of frequency sub-components as a function of said at least one transformation parameter ($\theta(b_1)$, ..., ($\theta(b_N)$)), said plurality of frequency sub-components comprising principal frequency sub-components ($CP(b_1)$, ..., $CP(b_N)$),
- combining at least a portion of said principal frequency sub-components ($CP(b_1)$, ..., $CP(b_N)$) in order to form a principal component (CP), and
- defining an encoded audio signal (SC) representing said multi-channel audio signal ($C_1$, ..., $C_M$), said encoded audio signal (SC) comprising said principal component (CP) and said at least one transformation parameter ($\theta(b_1)$, ..., ($\theta(b_N)$)).

2. Method according to Claim 1, **characterized in that** said plurality of frequency sub-components also comprises residual frequency sub-components ($A(b_1)$, ..., $A(b_N)$).

3. Method according to Claim 2, **characterized in that** it comprises a formation of a set of energy parameters ($E(b_1)$, ..., $E(b_N)$)) as a function of the residual frequency sub-components ($A(b_1)$, ..., $A(b_N)$).

4. Method according to Claim 3, **characterized in that** the set of energy components ($E(b_1)$, ..., $E(b_N)$)) is formed by an extraction of the energy differences per frequency sub-band between the principal frequency sub-components ($CP(b_1)$, ..., $CP(b_N)$) and the residual frequency sub-components ($A(b_1)$, ..., $A(b_N)$).

5. Method according to Claim 3, **characterized in that** the set of energy parameters ($E(b_1)$, ..., $E(b_N)$)) corresponds to the energies of the residual frequency sub-components ($A(b_1)$, ..., $A(b_N)$).

6. Method according to Claims 3 to 5, **characterized in that** it comprises a filtering of the principal frequency sub-components before the extraction of the set of energy parameters ($E(b_1)$, ..., $E(b_N)$)).

7. Method according to any one of Claims 3 to 6, **characterized in that** the encoded audio signal (SC) also comprises at least one energy parameter from said set of energy parameters ($E(b_1)$, ..., $E(b_N)$)).

8. Method according to any one of Claims 2 to 7, **characterized in that** it comprises a combination of at least a portion of said residual frequency sub-components in order to form at least one residual component (A) and **in that** the encoded audio signal also comprises said at least one residual component (A).

9. Method according to any one of Claims 1 to 8, **characterized in that** it comprises an analysis of correlation between said at least two channels (L, R) in order to determine a corresponding correlation value (c), and **in that** said encoded audio signal also comprises said correlation value (c).

10. Method according to any one of Claims 1 to 9, **characterized in that** said plurality of frequency sub-bands ($l(b_1)$, ..., $l(b_N)$, $r(b_1)$, ..., $r(b_N)$), is defined according to a perceptual scale.

11. Method according to Claim 7, **characterized in that** the definition of said encoded audio signal comprises an audio encoding of said principal component (CP) and a quantization of said at least one transformation parameter and/or a quantization of said at least one energy parameter E, and/or a quantization of said at least one residual component (A).

12. Method according to any one of Claims 1 to 11, **characterized in that** said audio signal is defined by a succession of frames so that said at least two channels (L, R) are defined for each frame n.

13. Method according to any one of Claims 1 to 12, **characterized in that** the multi-channel audio signal ($C_1$, ..., $C_M$) is a stereophonic signal.

14. Method according to any one of Claims 1 to 12, **characterized in that** the multi-channel audio signal ($C_1$, ..., $C_M$) is an audio signal in 5.1 format comprising the following channels: Left (L), Central (C), Right (R), Left Rear (Ls), Right rear (Rs) and Low Frequencies (LFE).

15. Method according to Claim 14, **characterized in that** it comprises the formation of a first triplet of signals comprising the Left, Central and Left Rear channels (L, C, Ls) and of a second triplet of signals comprising the Right, Central and Right Rear channels (R, C, Rs) and **in that** the first and second triplets are used separately to form first and second principal components (CP1, CP2) according to the transformation parameters comprising first and second Euler angles respectively.

**16.** Method for decoding a receive signal comprising an encoded audio signal constructed according to any one of Claims 1 to 15, **characterized in that** it comprises the following steps:

- receiving the encoded audio signal (SC),
- extracting a decoded principal component (CP') and at least one decoded transformation parameter,
- breaking down said decoded principal component (CP') into decoded principal frequency sub-components,
- transforming said decoded principal frequency sub-components into a plurality of decoded frequency sub-bands, and
- combining the decoded frequency sub-bands in order to form at least two decoded channels (L', R') corresponding to said at least two channels (L, R) originating from said original multi-channel audio signal.

**17.** Decoding method according to Claim 16, **characterized in that** it comprises the inverse quantization of energy parameters ($E(b_1)$, ..., $E(b_N)$)) comprised in the encoded audio signal in order to synthesize the decoded residual frequency sub-components ($A'(b_1)$, ..., $A'(b_N)$).

**18.** Decoding method according to Claim 17, **characterized in that** it comprises a step of decorrelation of the decoded residual frequency sub-components ($A'(b_1)$, ..., $A'(b_N)$) in order to form decorrelated residual sub-components ($A_H'(b_1)$, ..., $A_H'(b_N)$).

**19.** Decoding method according to Claim 18, **characterized in that** the decorrelation is carried out by a decorrelation or reverberation filtering according to a correlation value (c) comprised in the encoded audio signal.

**20.** Encoder (9) by principal component analysis (PCA) of a multi-channel audio signal ($C_1$, ..., CM), said encoder (9) being **characterized in that** it comprises:

- breakdown means (21) for breaking down at least two channels (L, R) of said audio signal into a plurality of frequency sub-bands ($l(b_1)$, ..., $l(b_N)$, $r(b_1)$, ..., $r(b_N)$).
- computing means (23) for computing at least one transformation parameter ($\theta(b_1)$, ..., ($\theta(b_N)$) as a function of at least a portion of said plurality of frequency sub-bands,
- transformation means (25) for transforming at least a portion of said plurality of frequency sub-bands into a plurality of frequency sub-components as a function of said at least one transformation parameter ($\theta(b_1)$, ..., ($\theta(b_N)$)), said plurality of frequency sub-components comprising principal frequency sub-components (CP($b_1$), ..., CP($b_N$)),

- combination means (27) for combining at least a portion of said principal frequency sub-components (CP($b_1$), ..., CP($b_N$)) in order to form a principal component (CP), and
- definition means (29) for defining an encoded audio signal (SC) representing said multi-channel audio signal ($C_1$, ..., $C_M$), said encoded audio signal (SC) comprising said principal component (CP) and said at least one transformation parameter ($\theta(b_1)$, ..., ($\theta(b_N)$).

**21.** Encoder (15) of a receive signal comprising an encoded audio signal (SC) originating from an original multi-channel signal comprising at least two channels (L, R), said decoder (15) being **characterized in that** it comprises:

- extraction means (41) for extracting a decoded principal component (CP') and at least one decoded transformation parameter,
- decoding breakdown means (43) for breaking down said decoded principal component (CP') into decoded frequency principal sub-components,
- inverse transformation means (47) for transforming said decoded principal frequency sub-components (CP'($b_1$), ..., CP' ($b_N$) ) into a plurality of decoded frequency sub-bands (l'($b_1$), ..., l'($b_N$)), and
- decoding combination means (49) for combining said decoded frequency sub-bands in order to form at least two decoded channels (L', R') corresponding to said at least two channels (L, R) originating from said original multi-channel audio signal.

**22.** System comprising the encoder according to Claim 20 and the decoder according to Claim 21.

**23.** Computer program that can be downloaded from a communication network and/or stored on a medium that can be read by computer and/or that can be executed by a microprocessor, **characterized in that** it comprises program code instructions for the execution of steps of the encoding method according to at least one of Claims 1 to 15, when it is executed on a computer.

**24.** Computer program that can be downloaded from a communication network and/or stored on a medium that can be read by computer and/or that can be executed by a microprocessor, **characterized in that** it comprises program code instructions for the execution of steps of the decoding method according to at least one of Claims 16 to 19, when it is executed on a computer.

**Patentansprüche**

1. Verfahren zur Codierung eines Mehrkanal-Audiosignals $(C_1, ..., C_M)$ durch Hauptkomponentenanalyse (ACP), **dadurch gekennzeichnet, dass** es die folgenden Schritte aufweist:

> - Zerlegen von mindestens zwei Kanälen (L, R) des Audiosignals in eine Vielzahl von Subfrequenzbändern $(l(b_1), ..., l(b_N), r(b_1), ..., r(b_N))$.
> - Berechnen mindestens eines Umwandlungsparameters $(\theta(b_1), ..., \theta(b_N))$ abhängig von mindestens einem Teil der Vielzahl von Subfrequenzbändern,
> - Umwandeln mindestens eines Teils der Vielzahl von Subfrequenzbändern in eine Vielzahl von Subfrequenzkomponenten abhängig von dem mindestens einen Umwandlungsparameter $(\theta(b_1), ..., \theta(b_N))$, wobei die Vielzahl von Subfrequenzkomponenten Haupt-Subfrequenzkomponenten $(CP(b_1), ..., CP(b_N))$ aufweist,
> - Kombinieren mindestens eines Teils der Haupt-Subfrequenzkomponenten $(CP(b_1), ..., CP(b_N))$, um eine Hauptkomponente (CP) zu formen und
> - Definieren eines codierten Audiosignals (SC), das das Mehrkanal-Audiosignal $(C_1, ..., C_M)$ darstellt, wobei das codierte Audiosignal (SC) die Hauptkomponente (CP) und den mindestens einen Umwandlungsparameter $(\theta(b_1), ..., \theta(b_N))$ aufweist.

2. Verfahren nach Anspruch 1, **dadurch gekennzeichnet, dass** die Vielzahl von Subfrequenzkomponenten außerdem Rest-Subfrequenzkomponenten $(A(b_1), ..., A(b_N))$ aufweist .

3. Verfahren nach Anspruch 2, **dadurch gekennzeichnet, dass** es eine Bildung einer Einheit von Energieparametern $(E(b_1), ..., E(b_N))$ abhängig von den Rest-Subfrequenzkomponenten $(A(b_1), ..., A(b_N))$ aufweist.

4. Verfahren nach Anspruch 3, **dadurch gekennzeichnet, dass** die Einheit von Energieparametern $(E(b_1), ..., E(b_N))$ durch Extrahieren der Subfrequenzbänder-Energiedifferenzen zwischen den Haupt-Subfrequenzkomponenten $(CP(b_1), ..., CP(b_N))$ und den Rest-Subfrequenzkomponenten $(A(b_1), ..., A(b_N))$ gebildet wird.

5. Verfahren nach Anspruch 3, **dadurch gekennzeichnet, dass** die Einheit von Energieparametern $(E(b_1), ..., E(b_N))$ den Energien der Rest-Subfrequenzkomponenten $(A(b_1), ..., A(b_N))$ entspricht.

6. Verfahren nach Anspruch 3 bis 5, **dadurch gekennzeichnet, dass** es eine Filterung der Haupt-Subfrequenzkomponenten vor dem Extrahieren der Einheit von Energieparametern $(E(b_1), ..., E(b_N))$ aufweist.

7. Verfahren nach einem der Ansprüche 3 bis 6, **dadurch gekennzeichnet, dass** das codierte Audiosignal (SC) außerdem mindestens einen Energieparameter aus der Einheit von Energieparametern $(E(b_1), ..., E(b_N))$ aufweist .

8. Verfahren nach einem der Ansprüche 2 bis 7, **dadurch gekennzeichnet, dass** es eine Kombination mindestens eines Teils der Rest-Subfrequenzkomponenten aufweist, um mindestens eine Restkomponente (A) zu bilden, und dass das codierte Audiosignal außerdem die mindestens eine Restkomponente (A) aufweist.

9. Verfahren nach einem der Ansprüche 1 bis 8, **dadurch gekennzeichnet, dass** es eine Korrelationsanalyse zwischen den mindestens zwei Kanälen (L, R) aufweist, um einen entsprechenden Korrelationswert (c) zu bestimmen, und dass das codierte Audiosignal außerdem den Korrelationswert (c) aufweist.

10. Verfahren nach einem der Ansprüche 1 bis 9, **dadurch gekennzeichnet, dass** die Vielzahl von Subfrequenzbändern $(l(b_1), ..., l(b_N), r(b_1), ..., r(b_N))$ gemäß einer Wahrnehmungsskala definiert wird.

11. Verfahren nach Anspruch 7, **dadurch gekennzeichnet, dass** die Definition des codierten Audiosignals eine Audiocodierung der Hauptkomponente (CP) und eine Quantisierung des mindestens einen Umwandlungsparameters und/oder eine Quantisierung des mindestens eine Energieparameters E und/oder eine Quantisierung der mindestens einen Restkomponente (A) aufweist.

12. Verfahren nach einem der Ansprüche 1 bis 11, **dadurch gekennzeichnet, dass** das Audiosignal durch eine Folge von Rahmen definiert wird, derart, dass die mindestens zwei Kanäle (L, R) für jeden Rahmen n definiert werden.

13. Verfahren nach einem der Ansprüche 1 bis 12, **dadurch gekennzeichnet, dass** das Mehrkanal-Audiosignal $(C_1, ..., C_M)$ ein stereophones Signal ist.

14. Verfahren nach einem der Ansprüche 1 bis 12, **dadurch gekennzeichnet, dass** das Mehrkanal-Audiosignal $(C_1, ..., C_M)$ ein Audiosignal im Format 5.1 ist, das die folgenden Kanäle aufweist: Links (L), Mitte (C), Rechts (R), Hinten Links (Ls), Hinten Rechts (Rs), und Niederfrequenzen (LFE).

**15.** Verfahren nach Anspruch 14, **dadurch gekennzeichnet, dass** es die Bildung eines ersten Triplets von Signalen, das die Kanäle Links, Mitte und Hinten Links (L, C, Ls) aufweist, und eines zweiten Triplets von Signalen aufweist, das die Kanäle Rechts, Mitte und Hinten Rechts (R, C, Rs) aufweist, und dass das erste und das zweite Triplet getrennt verwendet werden, um eine erste und eine zweite Hauptkomponente (CP1, CP2) gemäß Umwandlungsparametern zu formen, die erste bzw. zweite Euler-Winkel aufweisen.

**16.** Verfahren zum Decodieren eines Empfangssignals, das ein codiertes Audiosignal aufweist, das nach einem der Ansprüche 1 bis 15 konstruiert ist, **dadurch gekennzeichnet, dass** es die folgenden Schritte aufweist:

- Empfangen des codierten Audiosignals (SC),
- Extrahieren einer decodierten Hauptkomponente (CP') und mindestens eines decodierten Umwandlungsparameters,
- Zerlegen der decodierten Hauptkomponente (CP') in decodierte Haupt-Subfrequenzkomponenten,
- Umwandeln der decodierten Haupt-Subfrequenzkomponenten in eine Vielzahl von decodierten Subfrequenzbändern, und
- Kombinieren der decodierten Subfrequenzbänder, um mindestens zwei decodierte Kanäle (L', R') zu bilden, die den mindestens zwei Kanälen (L, R) entsprechen, die vom ursprünglichen Mehrkanal-Audiosignal stammen.

**17.** Decodierverfahren nach Anspruch 16, **dadurch gekennzeichnet, dass** es die inverse Quantisierung von Energieparametern ($E(b_1)$, ..., $E(b_N)$) aufweist, die im codierten Audiosignal enthalten sind, um decodierte Rest-Subfrequenzkomponenten ($A'(b_1)$, ..., $A'(b_N)$) zu synthetisieren.

**18.** Decodierverfahren nach Anspruch 17, **dadurch gekennzeichnet, dass** es einen Schritt der Dekorrelation der decodierten Rest-Subfrequenzkomponenten ($A'(b_1)$, ..., $A'(b_N)$) aufweist, um dekorrelierte Rest-Subkomponenten ($A_H'(b_1)$, ..., $A_H'(b_N)$) zu bilden.

**19.** Decodierverfahren nach Anspruch 18, **dadurch gekennzeichnet, dass** die Dekorrelation durch eine Dekorrelations- oder Nachhall-Filterung gemäß einem im codierten Audiosignal enthaltenen Korrelationswert (c) durchgeführt wird.

**20.** Codierer (9) durch Hauptkomponentenanalyse (ACP) eines Mehrkanal-Audiosignals ($C_1$, ..., $C_M$), wobei der Codierer (9) **dadurch gekennzeichnet ist, dass** er aufweist:

- Zerlegungseinrichtungen (21), um mindestens zwei Kanäle (L, R) des Audiosignals in eine Vielzahl von Subfrequenzbändern ($l(b_1)$, ..., $l(b_N)$, $r(b_1)$, ..., $r(b_N)$) zu zerlegen,
- Recheneinrichtungen (23), um mindestens einen Umwandlungsparameter ($\theta(b_1)$, ..., $\theta(b_N)$) abhängig von mindestens einem Teil der Vielzahl von Subfrequenzbändern zu berechnen,
- Umwandlungseinrichtungen (25), um mindestens einen Teil der Vielzahl von Subfrequenzbändern in eine Vielzahl von Subfrequenzkomponenten abhängig von dem mindestens einen Umwandlungsparameter ($\theta(b_1)$, ..., $\theta(b_N)$) umzuwandeln, wobei die Vielzahl von Subfrequenzkomponenten Haupt-Subfrequenzkomponenten ($CP(b_1)$ ..., $CP(b_N)$) aufweist,
- Kombinationseinrichtungen (27), um mindestens einen Teil der Haupt-Subfrequenzkomponenten ($CP(b_1)$, ..., $CP(b_N)$) zu kombinieren, um eine Hauptkomponente (CP) zu formen, und
- Definitionseinrichtungen (29), um ein codiertes Audiosignal (SC) zu definieren, das das Mehrkanal-Audiosignal ($C_1$, ... , $C_M$) darstellt, wobei das codierte Audiosignal (SC) die Hauptkomponente (CP) und den mindestens einen Umwandlungsparameter ($\theta(b_1)$, ..., $\theta(b_N)$) aufweist .

**21.** Decodierer (15) eines Empfangssignals, das ein codiertes Audiosignal (SC) aufweist, das von einem ursprünglichen Mehrkanal-Signal stammt, das mindestens zwei Kanäle (L, R) enthält, wobei der Decodierer (15) **dadurch gekennzeichnet ist, dass** er aufweist:

- Extrahierungseinrichtungen (41), um eine decodierte Hauptkomponente (CP') und mindestens einen decodierten Umwandlungsparameter zu extrahieren,
- Decodier-Zerlegungseinrichtungen (43), um die decodierte Hauptkomponente (CP') in decodierte Haupt-Subfrequenzkomponenten zu zerlegen,
- Einrichtungen zur inversen Umwandlung (47), um die decodierten Haupt-Subfrequenzkomponenten ($CP'(b_1)$, ..., $CP'(b_N)$) in eine Vielzahl von decodierten Subfrequenzbändern ($l'(b_1)$, ..., $l'(b_N)$) umzuwandeln, und
- Decodier-Kombinationseinrichtungen (49), um die decodierten Subfrequenzbänder zu kombinieren, um mindestens zwei decodierte Kanäle (L', R') zu bilden, die den mindestens zwei Kanälen (L, R) entsprechen, die vom ursprünglichen Mehrkanal-Audiosignal stammen.

**22.** System, das den Codierer nach Anspruch 20 und den Decodierer nach Anspruch 21 aufweist.

**23.** Computerprogramm, das von einem Kommunikationsnetzwerk heruntergeladen und/oder auf einem computerlesbaren Träger gespeichert und/oder von einem Mikroprozessor ausgeführt werden kann, **dadurch gekennzeichnet, dass** es Programmcodeanweisungen zur Ausführung der Schritte des Codierverfahrens nach mindestens einem der Ansprüche 1 bis 15 enthält, wenn es in einem Computer ausgeführt wird.

**24.** Computerprogramm, das von einem Kommunikationsnetzwerk heruntergeladen und/oder auf einem computerlesbaren Träger gespeichert und/oder von einem Mikroprozessor ausgeführt werden kann, **dadurch gekennzeichnet, dass** es Programmcodeanweisungen zur Ausführung der Schritte des Decodierverfahrens nach mindestens einem der Ansprüche 16 bis 19 enthält, wenn es in einem Computer ausgeführt wird.

C1....CM → **9** → SC 11

**7**

13

**15** → C1'....CM'

3

5

1

# FIG.1

FIG.2

FIG.3

FIG.4

FIG.5

FIG.6

FIG.7

FIG.8

FIG.9

FIG.10

EP 2 005 420 B1

FIG.11

FIG.12

FIG.13

FIG.14

EP 2 005 420 B1

FIG.15

FIG.16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03085643 A

- WO 03085645 A